# EUROPEAN PATENT APPLICATION

(11) **EP 4 579 717 A1**
(43) Date of publication of application: **02.07.2025**
(21) Application number: 23856946.1
(22) Date of filing: 20.06.2023
(51) Int. Cl.: H01L 21/304, B24B 5/50, B24B 27/06, B28D 5/04

(54) **CYLINDRICAL GRINDING DEVICE, CYLINDRICAL GRINDING METHOD, AND WAFER MANUFACTURING METHOD**

(30) Priority: 26.08.2022 JP 2022134571
(71) Applicant: SUMCO CORPORATION, Minato-ku, Tokyo 105-8634 (JP)
(72) Inventor: KOHINATA, Tomohito, Tokyo 105-8634 (JP); KANEHARA, Takahiro, Tokyo 105-8634 (JP)
(74) Representative: Kraus & Lederer PartGmbB
(86) International application number: PCT/JP2023/022706
(87) International publication number: WO 2024/042829

(57) **Abstract**

A cylindrical grinding apparatus produces a monocrystal for slicing by cylindrical grinding an outer circumferential surface of a monocrystal for grinding while rotating the monocrystal for grinding around a rotation axis. The cylindrical grinding apparatus includes: an attitude correcting section for correcting an attitude of the monocrystal for grinding to incline a center axis thereof with respect to the rotation axis, by rotating the monocrystal for grinding around the center axis and turning the monocrystal for grinding around a turn axis orthogonal to the center axis based on a plane orientation difference between a plane orientation of the monocrystal for grinding and a target plane orientation of a wafer to be obtained by slicing the monocrystal for slicing; and a grinding section for cylindrically grinding the outer circumferential surface of the monocrystal for grinding while rotating the monocrystal for grinding whose attitude has been corrected around the rotation axis.

## Description

### TECHNICAL FIELD

The present invention relates to a cylindrical grinding apparatus, a cylindrical grinding method and a wafer manufacturing method.

### BACKGROUND ART

It is said that integration technologies for providing a power delivery network at a lower part of a device will be employed in leading-edge logic products. Such logic products are each configured including a so-called bonded wafer, and produced by forming the device and the power delivery network on separate wafers and bonding the separate wafers via an insulating film.

It is predicted that wafer bonding accuracy of the bonded wafer affects forming Through Silicon Via (TSV) that connects the device and the power delivery network, and the wafer bonding accuracy is required to be improved.

As one method for improving the wafer bonding accuracy, it is considered to be useful to slice a monocrystalline silicon (monocrystal for slicing) in a state where a relationship between a position of a notch representing a plane orientation and a slicing start position is constantly a same specific relationship in a wire-saw process, thereby providing a constant generation state of fine waviness within a wafer surface with the notch serving as a reference. Wafers having such a constant generation state of waviness are bonded together so that respective notches of the wafers overlap each other, and thereby projections and recesses on surfaces of the wafers facing each other are fitted together, which improves the bonding accuracy.

However, a new problem as follows occurs when the above-described method is applied.

In a monocrystalline silicon produced by the Czochralski method (CZ method) or the like, a center axis of the monocrystalline silicon is sometimes displaced from a target crystal axis. When a monocrystal for slicing, which is obtained from the monocrystalline silicon having such a displacement, is sliced by a wire-saw, resultant wafers have plane orientations deviated from a target plane orientation.

A method described in Patent Literature 1 or Patent Literature 2 is considered to be used to solve this problem.

In the method described in Patent Literature 1, an orientation adjusting mechanism to which a monocrystal for slicing is attached is fixed to a slide table prior to slicing the monocrystal for slicing in a wire-saw process. Subsequently, a crystal axis orientation of the monocrystal for slicing in a vertical direction and a horizontal direction is detected. Then, on the basis of the detected crystal axis orientation in the vertical direction and the horizontal direction, the orientation adjusting mechanism is adjusted, so that the monocrystal for slicing parallel to a plane formed by a wire row is rotated by a predetermined angle around a center axis thereof, and is also horizontally turned by a predetermined angle around a turn axis (e.g. a vertical axis) orthogonal to the center axis.

In this method, it is considered to be possible to adjust the plane orientation of the monocrystal for slicing relative to the wire row and obtain wafers whose plane orientations coincide with a target plane orientation.

In contrast, in the method described in Patent Literature 2, when cylindrically grinding a monocrystalline silicon (a monocrystal for grinding), an axial displacement amount between the crystal axis and the center axis of the monocrystalline silicon is adjusted beforehand.

In this method, it is considered to be possible to obtain wafers whose plane orientations coincide with a target plane orientation.

### CITATION LIST

### PATENT LITERATURE(S)

Patent Literature 1: JP H10-100142 A
Patent Literature 2: JP 2017-212268 A

### SUMMARY OF THE INVENTION

### PROBLEM(S) TO BE SOLVED BY THE INVENTION

In the method described in Patent Literature 1, however, when slicing of a monocrystal for slicing is tried in a state where a relationship between the plane orientation represented by the position of a notch and a slicing start position is a specific relationship, a deviation in the vertical direction between the plane orientation of the monocrystal for slicing and the target plane orientation of wafers cannot be canceled even if the monocrystal for slicing is horizontally turned to adjust the plane orientation, in a case where the displacement between the center axis of the monocrystal for slicing and the target crystal axis is large.

Thus, wafers having a constant generation state of waviness with respect to the plane orientation cannot be obtained.

The method described in Patent Literature 2 has a purpose of obtaining wafers with favorable warp by slicing a monocrystalline silicon in a state where the monocrystalline silicon is placed so that an angle between a wire and a cleavage direction of a wafer is ±5 degrees or less at a maximum and an angle between the center axis of the monocrystalline silicon and a plane formed by a wire row is 0.1 degrees or less.

Accordingly, in the method described in Patent Literature 2, the monocrystalline silicon cannot be sliced in a state where the relationship between the plane orientation and the slicing start position is a specific relationship, and thus it is impossible to make the plane orientation of the wafers coincide with the target plane orientation in a case where the displacement between the center axis of the monocrystalline silicon and the target crystal axis is large. Consequently, wafers having a constant generation state of waviness with respect to the plane orientation cannot be obtained.

An object of the invention is to provide a cylindrical grinding apparatus, a cylindrical grinding method, and a wafer manufacturing method capable of producing, from a monocrystal for grinding having any plane orientation, a monocrystal for slicing from which wafers having a constant generation state of waviness with respect to the plane orientation is obtainable.

### MEANS FOR SOLVING THE PROBLEM(S)

A cylindrical grinding apparatus according to an aspect of the invention is a cylindrical grinding apparatus configured to produce a monocrystal for slicing by performing cylindrical grinding, in the cylindrical grinding an outer circumferential surface of a monocrystal for grinding being ground while the monocrystal for grinding is rotated around a rotation axis, the cylindrical grinding apparatus including: an attitude correcting section configured to correct an attitude of the monocrystal for grinding to incline a center axis of the monocrystal for grinding with respect to the rotation axis, by performing a rotation and a turn based on a plane orientation difference between a plane orientation of the monocrystal for grinding and a target plane orientation of a wafer to be obtained by slicing the monocrystal for slicing, in the rotation the monocrystal for grinding being rotated around the center axis, in the turn the monocrystal for grinding being turned around a turn axis orthogonal to the center axis; and a grinding section configured to cylindrically grind the outer circumferential surface of the monocrystal for grinding while rotating the monocrystal for grinding whose attitude has been corrected around the rotation axis.

In the cylindrical grinding apparatus according to the aspect of the invention, it is preferable that the grinding section includes a rotation section configured to hold and rotate the monocrystal for grinding around the rotation axis, a grinding member configured to grind the outer circumferential surface of the monocrystal for grinding, and a relative movement section configured to relatively move the rotation section and the grinding member along the rotation axis, and the attitude correcting section includes a turn section configured to perform the turn, and an attitude correction controller configured to control the rotation section to hold the monocrystal for grinding and perform the rotation in a state where the center axis is coincident with the rotation axis, and to control the turn section to receive the monocrystal for grinding from the rotation section, perform the turn, and then return the monocrystal for grinding to the rotation section.

**It** is preferable that the cylindrical grinding apparatus according to the aspect of the invention further includes: a correction amount computing section configured to obtain a first rotation angle for the rotation and a first turning angle for the turn, based on the plane orientation difference, in which the first rotation angle and the first turning angle enable a plane orientation of the monocrystal for slicing to coincide with the target plane orientation, and the cylindrical grinding apparatus is configured to perform first cylindrical grinding to produce the monocrystal for slicing whose plane orientation coincides with the target plane orientation, in the first cylindrical grinding the attitude correcting section performing the rotation based on the first rotation angle and the turn based on the first turning angle, and then the grinding section cylindrically grinding the outer circumferential surface of the monocrystal for grinding whose attitude has been corrected by the attitude correcting section.

It is preferable that the cylindrical grinding apparatus according to the aspect of the invention further includes: a grinding-possibility determining section configured to determine whether it is possible to cylindrically grind an entire outer circumferential surface of the monocrystal for grinding that has been turned by the first turning angle, based on a length and a diameter of the monocrystal for grinding and a target diameter of the monocrystal for slicing.

In the cylindrical grinding apparatus according to the aspect of the invention, it is preferable that when the grinding-possibility determining section determines that it is possible to cylindrically grind the entire outer circumferential surface of the monocrystal for grinding that has been turned by the first turning angle, the cylindrical grinding apparatus is configured to perform the first cylindrical grinding.

In the cylindrical grinding apparatus according to the aspect of the invention, it is preferable that when the grinding-possibility determining section determines that it is impossible to cylindrically grind the entire outer circumferential surface of the monocrystal for grinding that has been turned by the first turning angle, the correction amount computing section is configured to obtain a second rotation angle for the rotation and a second turning angle for the turn based on the plane orientation difference, the second turning angle being smaller than the first turning angle, the second rotation angle and the second turning angle do not enable the plane orientation of the monocrystal for slicing to coincide with the target plane orientation, and by rotating the monocrystal for slicing, in which a relationship between the plane orientation and a slicing start position is a predetermined relationship, by a set rotation angle around the center axis and then turning the monocrystal for slicing around the turn axis orthogonal to the center axis, the second rotation angle and the second turning angle enable the plane orientation of the monocrystal for slicing to coincide with the target plane orientation when viewed from a direction of the center axis before turning the monocrystal for slicing, and the cylindrical grinding apparatus is configured to perform second cylindrical grinding to produce the monocrystal for slicing whose plane orientation does not coincide with the target plane orientation, in the second cylindrical grinding the attitude correcting section performing the rotation based on the second rotation angle and the turn based on the second turning angle, and then the grinding section cylindrically grinding the outer circumferential surface of the monocrystal for grinding whose attitude has been corrected by the attitude correcting section.

In the cylindrical grinding apparatus according to the aspect of the invention, it is preferable that the grinding-possibility determining section is configured to determine whether it is possible to cylindrically grind the entire outer circumferential surface of the monocrystal for grinding that has been turned by the second turning angle, based on the length and the diameter of the monocrystal for grinding and the target diameter of the monocrystal for slicing.

In the cylindrical grinding apparatus according to the aspect of the invention, it is preferable that the cylindrical grinding apparatus is configured to perform the second cylindrical grinding when the grinding-possibility determining section determines that it is possible to cylindrically grind the entire outer circumferential surface of the monocrystal for grinding that has been turned by the second turning angle, and the cylindrical grinding apparatus is configured not to perform the second cylindrical grinding when the grinding-possibility determining section determines that it is impossible to cylindrically grind the entire outer circumferential surface of the monocrystal for grinding that has been turned by the second turning angle.

It is preferable that the cylindrical grinding apparatus according to the aspect of the invention further includes: a notch forming section configured to form a notch at the monocrystal for slicing, the notch representing the target plane orientation.

It is preferable that the cylindrical grinding apparatus according to the aspect of the invention further includes: a notch formation controller configured to select, of a plurality of notch forming candidate positions representing the target plane orientation, a notch forming candidate position that allows the first turning angle to be minimized; and a notch forming section configured to form a notch in the notch forming candidate position selected by the notch formation controller, at the monocrystal for slicing.

It is preferable that the cylindrical grinding apparatus according to the aspect of the invention further includes: a notch formation controller configured to select, of a plurality of notch forming candidate positions representing the target plane orientation, a notch forming candidate position that allows the second turning angle to be minimized; and a notch forming section configured to form a notch in the notch forming candidate position selected by the notch formation controller, at the monocrystal for slicing.

A cylindrical grinding method according to another aspect of the invention is a cylindrical grinding method of producing a monocrystal for slicing by cylindrically grinding an outer circumferential surface of a monocrystal for grinding while rotating the monocrystal for grinding around a rotation axis, the cylindrical grinding method including: correcting an attitude of the monocrystal for grinding to incline a center axis of the monocrystal for grinding with respect to the rotation axis, by performing a rotation and a turn based on a plane orientation difference between a plane orientation of the monocrystal for grinding and a target plane orientation of a wafer to be obtained by slicing the monocrystal for slicing, in the rotation the monocrystal for grinding being rotated around the center axis, in the turn the monocrystal for grinding being turned around a turn axis orthogonal to the center axis; and performing grinding, by cylindrically grinding the outer circumferential surface of the monocrystal for grinding while rotating the monocrystal for grinding whose attitude has been corrected around the rotation axis.

In the cylindrical grinding method according to the other aspect of the invention, it is preferable that a rotation section to hold and rotate the monocrystal for grinding around the rotation axis and a turn section to perform the turn are used, and in the correcting the attitude, the rotation section is controlled to hold the monocrystal for grinding and perform the rotation in a state where the center axis is coincident with the rotation axis, and then the turn section is controlled to receive the monocrystal for grinding from the rotation section, perform the turn, and then return to the rotation section the monocrystal for grinding in an attitude in which the center axis is inclined with respect to the rotation axis.

It is preferable that the cylindrical grinding method according to the other aspect of the invention further includes: calculating a correction amount by obtaining a first rotation angle for the rotation and a first turning angle for the turn based on the plane orientation difference, in which the first rotation angle and the first turning angle enable a plane orientation of the monocrystal for slicing to coincide with the target plane orientation, in the correcting the attitude, the rotation section is controlled to perform the rotation based on the first rotation angle, and then the turn section is controlled to perform the turn based on the first turning angle, and in the performing the grinding, the monocrystal for slicing whose plane orientation coincides with the target plane orientation is produced, by cylindrically grinding the outer circumferential surface of the monocrystal for grinding whose attitude has been corrected based on the first rotation angle and the first turning angle.

It is preferable that the cylindrical grinding method according to the other aspect of the invention further includes: determining a grinding possibility, in which it is determined whether it is possible to cylindrically grind an entire outer circumferential surface of the monocrystal for grinding that has been turned by the first turning angle, based on a length and a diameter of the monocrystal for grinding and a target diameter of the monocrystal for slicing, in which when it is determined, in the determining the grinding possibility, to be possible to cylindrically grind the entire outer circumferential surface of the monocrystal for grinding that has been turned by the first turning angle, the monocrystal for slicing whose plane orientation coincides with the target plane orientation is produced in the correcting the attitude and the performing the grinding.

In the cylindrical grinding method according to the other aspect of the invention, it is preferable that when it is determined, in the determining the grinding possibility, to be impossible to cylindrically grind the entire outer circumferential surface of the monocrystal for grinding that has been turned by the first turning angle, a second rotation angle for the rotation and a second turning angle for the turn are obtained based on the plane orientation difference in the calculating the correction amount, the second turning angle being smaller than the first turning angle, the second rotation angle and the second turning angle do not enable the plane orientation of the monocrystal for slicing to coincide with the target plane orientation, and by rotating the monocrystal for slicing, in which a relationship between the plane orientation and a slicing start position is a predetermined relationship, by a set rotation angle around the center axis and then turning the monocrystal for slicing around the turn axis orthogonal to the center axis, the second rotation angle and the second turning angle enable the plane orientation of the monocrystal for slicing to coincide with the target plane orientation when viewed from a direction of the center axis before turning the monocrystal for slicing, and when the second rotation angle and the second turning angle are obtained in the calculating the correction amount, the rotation section is controlled to perform the rotation based on the second rotation angle and then the turn section is controlled to perform the turn based on the second turning angle in the correcting the attitude, and the monocrystal for slicing whose plane orientation does not coincide with the target plane orientation is produced by cylindrically grinding the outer circumferential surface of the monocrystal for grinding whose attitude has been corrected based on the second rotation angle and the second turning angle in the performing the grinding.

In the cylindrical grinding method according to the other aspect of the invention, it is preferable that in the determining the grinding possibility, it is determined whether it is possible to cylindrically grind the entire outer circumferential surface of the monocrystal for grinding that has been turned by the second turning angle, based on the length and the diameter of the monocrystal for grinding and the target diameter of the monocrystal for slicing, when it is determined, in the determining the grinding possibility, to be possible to cylindrically grind the entire outer circumferential surface of the monocrystal for grinding that has been turned by the second turning angle, the monocrystal for slicing whose plane orientation does not coincide with the target plane orientation is produced in the correcting the attitude and the performing the grinding, and when it is determined to be impossible to cylindrically grind the entire outer circumferential surface of the monocrystal for grinding that has been turned by the second turning angle, the monocrystal for slicing whose plane orientation does not coincide with the target plane orientation is not produced in the correcting the attitude and the performing the grinding.

It is preferable that the cylindrical grinding method according to the other aspect of the invention further includes: forming a notch at the monocrystal for slicing, the notch representing the target plane orientation.

It is preferable that the cylindrical grinding method according to the other aspect of the invention further includes: controlling notch formation by selecting, of a plurality of notch forming candidate positions representing the target plane orientation, a notch forming candidate position that allows the first turning angle to be minimized; and forming a notch in the notch forming candidate position selected in the controlling the notch formation, at the monocrystal for slicing.

It is preferable that the cylindrical grinding method according to the other aspect of the invention further includes: controlling notch formation by selecting, a plurality of notch forming candidate positions representing the target plane orientation, a notch forming candidate position that allows the second turning angle to be minimized; and forming a notch in the notch forming candidate position selected in the controlling the notch formation, at the monocrystal for slicing.

A wafer manufacturing method according to still another aspect of the invention includes: producing a monocrystal for slicing from a monocrystal for grinding by the cylindrical grinding method described above; and manufacturing a plurality of wafers by slicing the monocrystal for slicing, the plurality of wafers each having a plane orientation coinciding with the target plane orientation.

### BRIEF DESCRIPTION OF DRAWINGS

Fig. 1 is a schematic view illustrating characteristics of a wafer according to an exemplary embodiment.
Fig. 2 is a block diagram illustrating a schematic configuration of a wafer manufacturing system according to the exemplary embodiment.
Fig. 3 is a plan view illustrating a schematic configuration of a cylindrical grinding apparatus according to the exemplary embodiment.
Fig. 4 is a side view illustrating a schematic configuration of a horizontal turn section included in the cylindrical grinding apparatus according to the exemplary embodiment.
Fig. 5 is a block diagram of a grinding controller included in the cylindrical grinding apparatus according to the exemplary embodiment.
Fig. 6 is a diagram for explaining a method of calculating a maximum horizontal turning angle of a monocrystal for grinding according to the exemplary embodiment.
Fig. 7 is a view illustrating a schematic configuration of a slicing device according to the exemplary embodiment.
Fig. 8 is a flowchart of a wafer manufacturing method according to the exemplary embodiment.
Fig. 9 is a flowchart of a first wafer manufacturing process according to the exemplary embodiment.
Fig. 10 is a schematic view illustrating an outline of the first wafer manufacturing process according to the exemplary embodiment.
Fig. 11 is a flowchart of a second wafer manufacturing process according to the exemplary embodiment.
Fig. 12 is a schematic view illustrating an outline of the second wafer manufacturing process according to the exemplary embodiment.
Fig. 13 is a schematic view illustrating a first modification and a second modification.
Fig. 14A is a view in a form of graph illustrating simulation results for a wafer manufacturing method of Comparative, which represents plane orientations of the monocrystal for grinding from which target wafers were manufactured.
Fig. 14B is a view in a form of graph illustrating the simulation results for the wafer manufacturing method of Comparative, which represents plane orientations of the monocrystal for grinding from which the target wafers were not manufactured.
Fig. 15A is a view in a form of graph illustrating simulation results for a wafer manufacturing method of Example, which represents plane orientations of the monocrystal for grinding from which the wafers were manufactured through the first wafer manufacturing process.
Fig. 15B is a view in a form of graph illustrating the simulation results for the wafer manufacturing method of Example, which represents plane orientations of the monocrystal for grinding from which the target wafers were manufactured and a plane orientation of the monocrystal for grinding from which the target wafers were not manufactured, through the second wafer manufacturing process.

### DESCRIPTION OF EMBODIMENT(S)

### Exemplary Embodiment(s)

An exemplary embodiment of the invention will be described below.

### Characteristics of Wafer

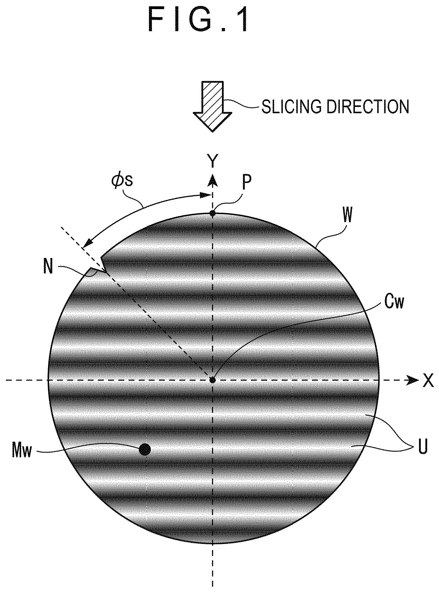

The characteristics of a wafer manufactured by a wafer manufacturing method of the exemplary embodiment will be described first. Fig. 1 is a schematic view illustrating the characteristics of the wafer.

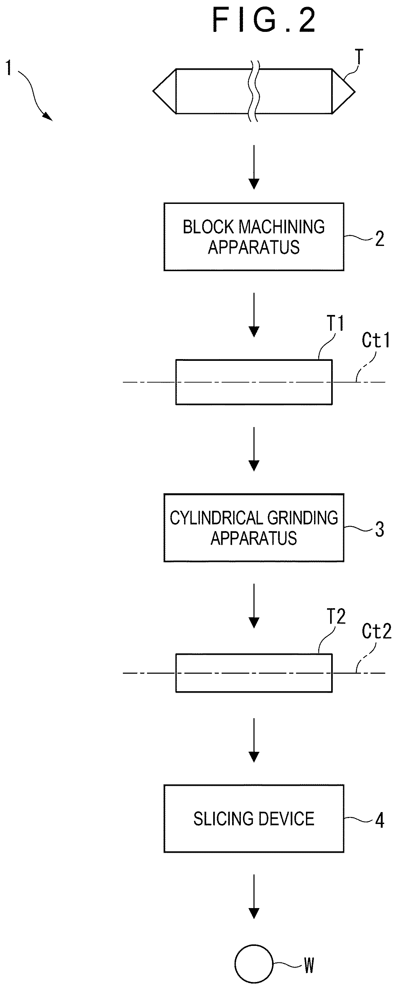

A wafer W illustrated in Fig. 1 is made of silicon, and manufactured by slicing cylindrical-shaped monocrystal for slicing T2 (see Fig. 2). The wafer W is, for instance, used for forming a bonded wafer. It should be noted that the wafer W may be made of germanium, silicon carbide, gallium arsenide, indium arsenide, gallium nitride, aluminum nitride, or the like.

Assuming that an axis parallel to a slicing direction is defined as a Y axis and an axis orthogonal to a center axis Cw of the wafer W and parallel to a horizontal direction is defined as an X axis, in a coordinate system having the Y axis and the X axis, a notch N representing a plane orientation Mw (hereinafter, occasionally referred to as a "target plane orientation Mw") of the wafer W is at a position where an angle on the Y axis between an imaginary line connecting a slicing start position P and the center axis Cw and an imaginary line connecting the notch N and the center axis Cw is a set rotation angle φs. That is, a positional relationship between the target plane orientation Mw of the wafer W and the slicing start position P has a specific relationship. In addition, waviness U orthogonal to the slicing direction is generated on the wafer W.

It should be noted that the set rotation angle φs is changeable depending on, for instance, the characteristics of the bonded wafer.

### Configuration of Wafer Manufacturing System

The configuration of the wafer manufacturing system used for manufacturing the wafers W will be described next. Fig. 2 is a block diagram illustrating a schematic configuration of the wafer manufacturing system.

A wafer manufacturing system 1 illustrated in Fig. 2 manufactures the wafers W having a constant generation state of the waviness U with the notch N and the target plane orientation Mw as illustrated in Fig. 1 serving as references, using a monocrystalline silicon ingot T produced by the Czochralski method or the like. The wafer manufacturing system 1 includes a block machining apparatus 2, a cylindrical grinding apparatus 3, and a slicing device 4.

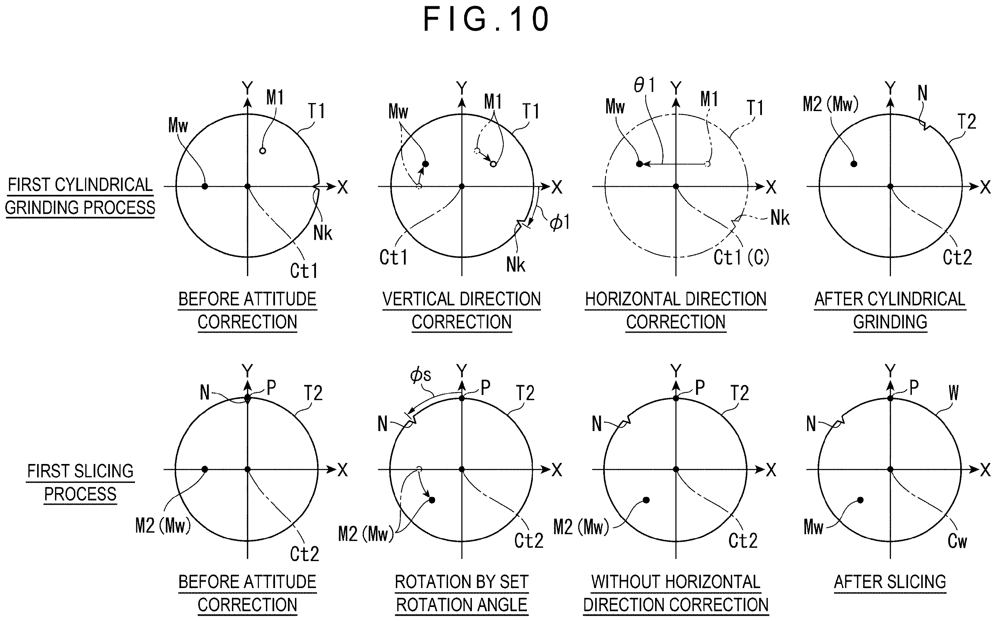

The block machining apparatus 2 includes a temporary cylindrical grinding device and a band saw that are not illustrated. The temporary cylindrical grinding device grinds an outer circumferential surface of the monocrystalline silicon ingot T to form a temporary notch Nk (see, for instance, Fig. 10) at a position in accordance with a crystal orientation. The band saw cuts the monocrystalline silicon ingot T into multiple pieces of monocrystal for grinding T1 each having a cylindrical shape.

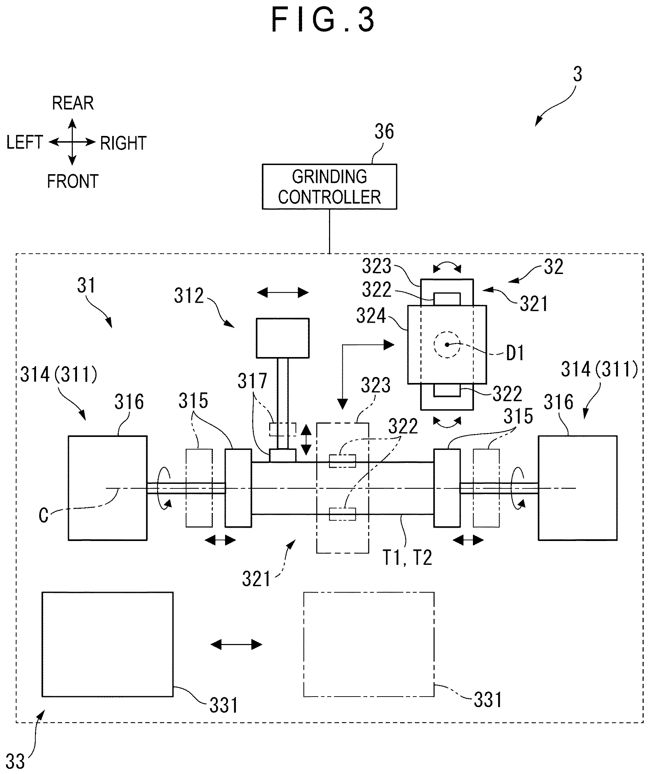

The cylindrical grinding apparatus 3 cylindrically grinds an outer circumferential surface of the monocrystal for grinding T1 in a state where a center axis Ct1 of the monocrystal for grinding T1 is inclined with respect to a rotation axis C (see Fig. 3) for cylindrical grinding, thereby machining the monocrystal for grinding T1 into the monocrystal for slicing T2 whose plane orientation has been corrected. In a cylindrical grinding process by the cylindrical grinding apparatus 3, the monocrystal for grinding T1 is machined into the monocrystal for slicing T2 whose plane orientation M2 (hereinafter, occasionally referred to as a "plane orientation after grinding M2") (see, for instance, Fig. 10) coincides with the target plane orientation Mw of the wafer W, or the monocrystal for slicing T2 whose plane orientation after grinding M2 does not coincide with the target plane orientation Mw.

The slicing device 4 slices the monocrystal for slicing T2 with, for instance, a wire saw, thereby machining the monocrystal for slicing T2 into a plurality of the wafers W each having a plane orientation coinciding with the target plane orientation Mw. In a slicing process of the slicing device 4, the monocrystal for slicing T2 whose plane orientation after grinding M2 coincides with the target plane orientation Mw is sliced in a state where a plane to be sliced of the monocrystal for slicing T2 is orthogonal to a center axis Ct2 of the monocrystal for slicing T2. In the slicing process, the monocrystal for slicing T2 whose plane orientation after grinding M2 does not coincide with the target plane orientation Mw is sliced in a state where the plane to be sliced of the monocrystal for slicing T2 is not orthogonal to the center axis Ct2 of the monocrystal for slicing T2 so that the plane orientations of the wafers W coincide with the target plane orientation Mw.

### Configuration of Cylindrical Grinding Apparatus

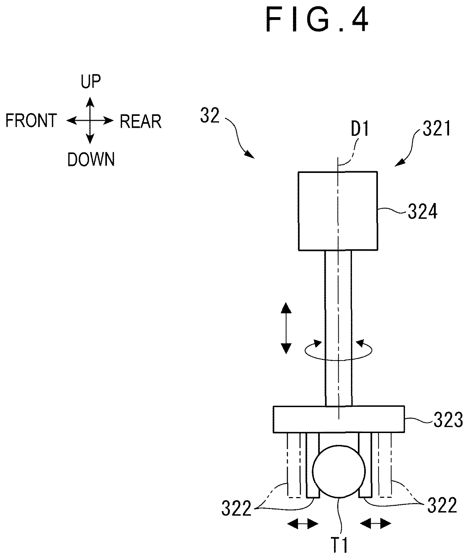

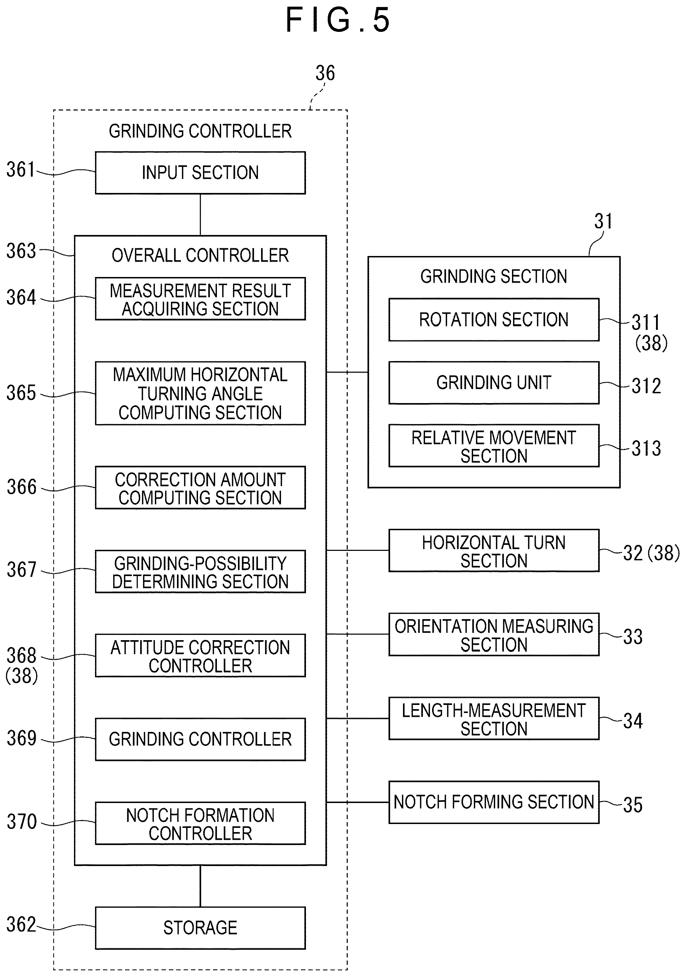

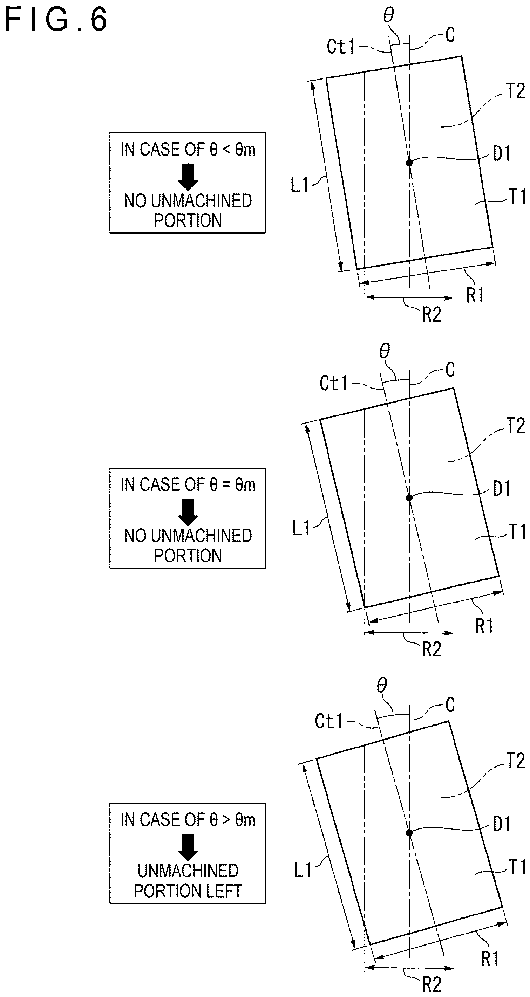

The configuration of the cylindrical grinding apparatus will be described next. Fig. 3 is a plan view illustrating a schematic configuration of the cylindrical grinding apparatus. Fig. 4 is a side view illustrating a schematic configuration of a horizontal turn section included in the cylindrical grinding apparatus. Fig. 5 is a block diagram of a grinding controller included in the cylindrical grinding apparatus. Fig. 6 is a diagram for explaining a method of calculating a maximum horizontal turning angle of the monocrystal for grinding.

As illustrated in Fig. 3, the cylindrical grinding apparatus 3 includes a grinding section 31, a horizontal turn section 32 serving as a turn section, an orientation measuring section 33, a length-measurement section 34 (see Fig. 5), a notch forming section 35 (see Fig. 5), and a grinding controller 36. It should be noted that arranged positions of respective components of the cylindrical grinding apparatus 3 will be described with directions indicated in Figs. 3 and 4 serving as fiducial directions.

The grinding section 31 includes a rotation section 311, a grinding unit 312, and a relative movement section 313 (see Fig. 5).

The rotation section 311 holds the monocrystal for grinding T1 and performs a rotation process of rotating the monocrystal for grinding T1 around the rotation axis C extending in a right-left direction. The rotation section 311 includes a pair of rotating-holding units 314, and a rotating-holding-unit moving section (not illustrated) for moving the pair of rotating-holding units 314 close to or away from each other along the rotation axis C.

The rotating-holding units 314 each include a chuck 315 for holding an end of the monocrystal for grinding T1 in a center axis Ct1 direction, and a chuck driver 316 for rotating the chuck 315 around the rotation axis C.

The rotation section 311 rotates the monocrystal for grinding T1 around the rotation axis C, using the chucks 315 of the rotating-holding units 314, in a state where the center axis Ct1 is coincident with the rotation axis C or the center axis Ct1 is inclined with respect to the rotation axis C.

The grinding unit 312 includes a grinding member 317, and a grinding-member moving section (not illustrated) for moving the grinding member 317 close to or away from the outer circumferential surface of the monocrystal for grinding T1. The grinding member 317 comes into contact with a rear portion of the outer circumferential surface of the monocrystal for grinding T1 rotating by drive of the rotation section 311, and grinds the outer circumferential surface of the monocrystal for grinding T1.

The relative movement section 313 moves the grinding unit 312 along the rotation axis C relative to the rotating-holding units 314. The grinding unit 312 is moved along the rotation axis C while the grinding member 317 is kept in contact with the outer circumferential surface of the rotating monocrystal for grinding T1, and thereby the outer circumferential surface of the monocrystal for grinding T1 can be cylindrically ground.

It should be noted that, when the cylindrical grinding is performed, the rotating-holding units 314 may be moved along the rotation axis C without moving the grinding unit 312, or both of the grinding unit 312 and the rotating-holding units 314 may be moved along the rotation axis C.

The horizontal turn section 32 receives the monocrystal for grinding T1 from the rotation section 311, horizontally turns the monocrystal for grinding T1 around a vertical axis D1 serving as a turn axis that is orthogonal to and intersects the center axis Ct1. Then, the horizontal turn section 32 returns to the rotation section 311 the monocrystal for grinding T1 with a horizontally turned attitude being kept. The horizontal turn section 32 includes a horizontal turn unit 321, and a horizontal-turn-unit moving section (not illustrated) for moving the horizontal turn unit 321 in front, rear, right and left directions.

It should be noted that the horizontal turning of the monocrystal for grinding T1 around the vertical axis D1 is exemplified in the exemplary embodiment. However, the monocrystal for grinding T1 may be turned around a turn axis that is orthogonal to and intersects the center axis Ct1 and is inclined with respect to the vertical axis D1.

The horizontal turn unit 321 includes: a pair of arms 322 for holding a front side or a rear side of a side surface of the monocrystal for grinding T1; an arm driver 323 for moving the pair of arms 322 close to or away from each other; and a lift-turn driver 324 for raising and lowering the arm driver 323 and horizontally turning the arm driver 323 around the vertical axis D1 as illustrated in Fig. 4.

Details of a process performed by the horizontal turn section 32 will be described later.

The orientation measuring section 33 measures a plane orientation M1 (hereinafter, occasionally referred to as a "plane orientation before grinding M1") of the monocrystal for grinding T1 held by the rotation section 311 (see, for instance, Fig. 10) and a notch orientation of the monocrystal for slicing T2. The orientation measuring section 33 includes an X-ray unit 331 for measuring the plane orientation before grinding M1 and the notch orientation, and an X-ray-unit moving section (not illustrated) for moving the X-ray unit 331 in right and left directions.

The X-ray unit 331 measures the plane orientation before grinding M1 or the notch orientation by X-ray irradiation and outputs signals representing measurement results to the grinding controller 36.

The length-measurement section 34 measures a length L1 (see Fig. 6) in an axial direction and a diameter R1 (see Fig. 6) of the monocrystal for grinding T1, and outputs signals representing measurement results to the grinding controller 36.

The notch forming section 35 forms the notch N (see, for instance, Fig. 10) at the monocrystal for slicing T2.

As illustrated in Fig. 5, the grinding controller 36 is configured to be capable of transmitting and receiving various information to and from the grinding section 31, the horizontal turn section 32, the orientation measuring section 33, the length-measurement section 34, and the notch forming section 35. The grinding controller 36 includes an input section 361, a storage 362, and an overall controller 363.

The input section 361 is, for instance, is provided in a form of a touch panel or a physical button. The input section 361 is used, for instance, for input operations of various settings relating to the cylindrical grinding by a worker, and outputs signals corresponding to the input operations to the overall controller 363.

The storage 362 stores various information relating to the cylindrical grinding to be readable by the overall controller 363. Examples of the information relating to the cylindrical grinding may include a target diameter R2 (see Fig. 6) of the monocrystal for slicing T2, the target plane orientation Mw, and the set rotation angle φs.

The overall controller 363 includes a CPU, and executes various functions by the CPU running a program stored in the storage 362. The overall controller 363 includes a measurement result acquiring section 364, a maximum horizontal turning angle computing section 365, a correction amount computing section 366, a grinding-possibility determining section 367, an attitude correction controller 368, a grinding controller 369, and a notch formation controller 370.

The measurement result acquiring section 364 controls the orientation measuring section 33 to acquire measurement results of the plane orientation before grinding M1 or the notch orientation of the monocrystal for slicing T2 from the orientation measuring section 33. The measurement result acquiring section 364 controls the length-measurement section 34 to acquire measurement results of the length L1 and the diameter R1 of the monocrystal for grinding T1.

It should be noted that the measurement result acquiring section 364 may acquire information on the length L1 and the diameter R1 of the monocrystal for grinding T1 input by a worker through the input section 361.

The maximum horizontal turning angle computing section 365 calculates a maximum horizontal turning angle θm for the horizontal turning of the monocrystal for grinding T1 around the vertical axis D1, on the basis of the length L1 and the diameter R1 of the monocrystal for grinding T1 and the target diameter R2 of the monocrystal for slicing T2. The maximum horizontal turning angle θm is an angle that satisfies conditions provided in Fig. 6.

When a horizontal turning angle θ of the monocrystal for grinding T1 is less than the maximum horizontal turning angle θm as illustrated in a topmost diagram of Fig. 6, and when the horizontal turning angle θ is equal to the maximum horizontal turning angle θm as illustrated in a center diagram of Fig. 6, the monocrystal for grinding T1 can be machined into the monocrystal for slicing T2 by cylindrically grinding an entire outer circumferential surface of the monocrystal for grinding T1 to have the target diameter R2. Thus, unmachined portions are not left.

In contrast, when the horizontal turning angle θ exceeds the maximum horizontal turning angle θm as illustrated in a bottommost diagram of Fig. 6, the monocrystal for grinding T1 cannot be machined into the monocrystal for slicing T2 because the entire outer circumferential surface of the monocrystal for grinding T1 cannot be cylindrically ground to have the target diameter R2, which generates unmachined portions.

In other words, the maximum horizontal turning angle θm is a threshold angle that serves as a criterion for determining whether it is possible to cylindrically grind the entire outer circumferential surface of the monocrystal for grinding T1 to have the target diameter R2.

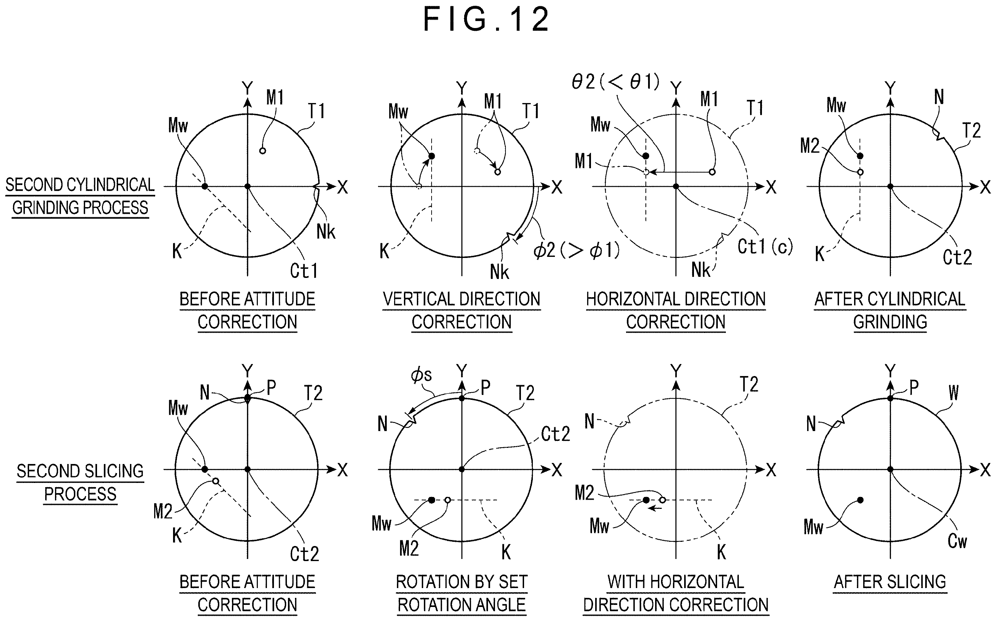

The correction amount computing section 366 calculates a first correction amount and a second correction amount to be used for obtaining the monocrystal for slicing T2 whose plane orientation is corrected from that of the monocrystal for grinding T1. The first correction amount includes a first rotation angle φ1 (see Fig. 10), and a first horizontal turning angle θ1 (see Fig. 10) as a first turning angle. The second correction amount includes a second rotation angle φ2 (see Fig. 12), and a second horizontal turning angle θ2 (see Fig. 12) as a second turning angle. The first and second rotation angles φ1 and φ2 are each a rotation angle around the center axis Ct1 of the monocrystal for grinding T1. The first and second horizontal turning angles θ1 and θ2 are each a horizontal turning angle around the vertical axis D1 of the monocrystal for grinding T1.

The correction amount computing section 366 calculates the first and second correction amounts on the basis of a difference between the plane orientation before grinding M1 and the target plane orientation Mw (hereinafter, occasionally referred to as a "plane orientation difference"). A method of calculating the first and second correction amounts will be described later.

The grinding-possibility determining section 367 determines, on the basis of a magnitude relationship between the maximum horizontal turning angle θm and the first horizontal turning angle θ1 or the second horizontal turning angle θ2, whether it is possible to cylindrically grind the entire outer circumferential surface of the monocrystal for grinding T1 to have the target diameter R2, when the monocrystal for grinding T1 is horizontally turned by the first horizontal turning angle θ1 or the second horizontal turning angle θ2.

The attitude correction controller 368 configures an attitude correcting section 38, together with the rotation section 311 and the horizontal turn section 32. The attitude correction controller 368 controls the rotation section 311 to perform a rotation process of rotating the monocrystal for grinding T1 around the center axis Ct1, and also controls the horizontal turn section 32 to perform a horizontal turn process of horizontally turning the monocrystal for grinding T1 around the vertical axis D1. Thus, the attitude correction controller 368 corrects the attitude of the monocrystal for grinding T1 to incline the center axis Ct1 with respect to the rotation axis C of the grinding section 31.

Herein, "correcting the attitude of the monocrystal for grinding T1" refers to correcting (adjusting) an axial direction of the center axis Ct1 of the monocrystal for grinding T1 relative to the rotation axis C of the grinding section 31 to be in a predetermined direction.

Specifically, after rotating the monocrystal for grinding T1 held by the pair of rotating-holding units 314 by the first rotation angle φ1, the attitude correction controller 368 causes the pair of arms 322 located at an initial position to move and hold the monocrystal for grinding T1. The attitude correction controller 368 releases the holding of the monocrystal for grinding T1 by the pair of rotating-holding units 314.

The attitude correction controller 368 raises the monocrystal for grinding T1 and then horizontally turns the monocrystal for grinding T1 by the first horizontal turning angle θ1, by drive of the lift-turn driver 324. The attitude correction controller 368 moves the monocrystal for grinding T1 into a space between the pair of rotating-holding units 314 while maintaining the horizontally turned attitude of the monocrystal for grinding T1. The attitude correction controller 368 causes the pair of rotating-holding units 314 to hold the monocrystal for grinding T1, and then releases the holding of the monocrystal for grinding T1 by the pair of arms 322. Finally, the attitude correction controller 368 returns the pair of arms 322 to the initial position.

The process performed by the attitude correcting section 38 as described above causes the pair of rotating-holding units 314 to hold the monocrystal for grinding T1 in an attitude rotated by the first rotation angle φ1 and horizontally turned by the first horizontal turning angle θ1 relative to an attitude of the monocrystal for grinding T1 in which the center axis Ct1 is coincident with the rotation axis C.

Further, by performing a process similar to the above-described process, the attitude correcting section 38 causes the pair of chucks 315 to hold the monocrystal for grinding T1 in an attitude rotated by the second rotation angle φ2 and horizontally turned by the second horizontal turning angle θ2 relative to the attitude of the monocrystal for grinding T1 in which the center axis Ct1 is coincident with the rotation axis C.

The grinding controller 369 controls the grinding section 31 to rotate the monocrystal for grinding T1 whose attitude has been corrected by control of the attitude correction controller 368, and move the monocrystal for grinding T1 along the rotation axis C while keeping the grinding member 317 in contact with the outer circumferential surface of the monocrystal for grinding T1, thereby performing the cylindrical grinding. The monocrystal for slicing T2 can be obtained by the above-described cylindrical grinding.

The notch formation controller 370 controls the notch forming section 35, on the basis of measurement results of the notch orientation of the monocrystal for slicing T2, and forms the notch N at a position corresponding to the notch orientation on an outer circumferential surface of the monocrystal for slicing T2. That is, the notch formation controller 370 forms the notch **N,** which represents the plane orientation after grinding M2 of the monocrystal for slicing T2, at the monocrystal for slicing T2.

### Configuration of Slicing Device

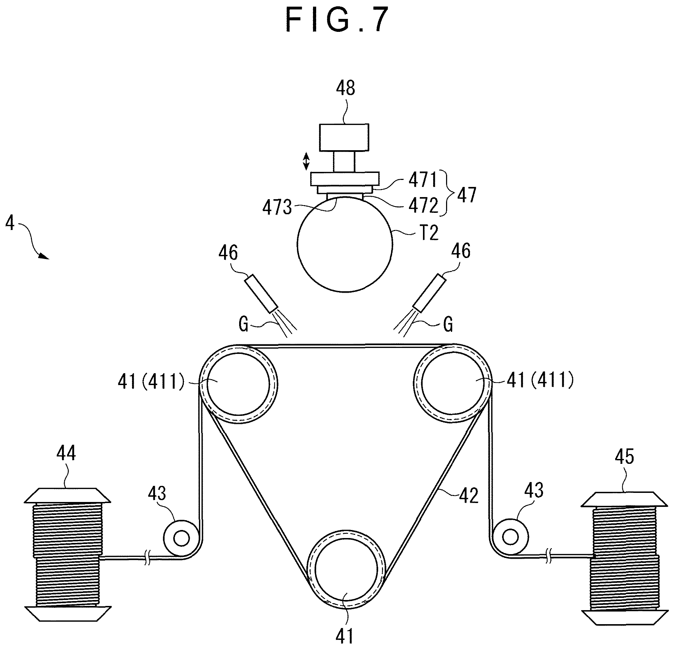

The configuration of the slicing device will be described next. Fig. 7 is a view illustrating a schematic configuration of the slicing device.

As illustrated in Fig. 7, the slicing device 4 is a so-called wire saw, and includes three main rollers 41, of which two main rollers 41 are disposed on a same horizontal plane and one main roller 41 is disposed below the two main rollers 41 at a middle position between the two main rollers 41.

Wires 42 are wrapped around the three main rollers 41 along axial directions thereof. Wrapping the wires 42 around the three main rollers 41 provides a wire row in which a plurality of the wires 42 are disposed, at a constant pitch along the axial directions of the main rollers 41, between the two main rollers 41 at an upper side (hereinafter, occasionally referred to as "upper main rollers 411").

Wire reels 44 and 45 for sending and winding the wires 42 through guide rollers 43 are disposed at both ends of the wires 42.

Nozzles 46, for supplying slurry G to a middle position between the two upper main rollers 411, are respectively disposed above the upper main rollers 411.

A lifting section 48 for raising and lowering the monocrystal for slicing T2 held by a holding member 47 is disposed above the nozzles 46.

The holding member 47 includes a work plate 471 having one main surface fixed to the lifting section 48, and a slicing table 472 fixed to the other main surface of the work plate 471.

The work plate 471 is a rectangular-shaped plate member whose both main surfaces are flat.

The slicing table 472 is a roughly rectangular-shaped plate member, and is cut by the wires 42 together with the monocrystal for slicing T2. The slicing table 472 includes a holding surface 473 having an arc surface shape for holding the monocrystal for slicing T2 through an adhesive agent. The holding surface 473 holds the monocrystal for slicing T2 in a state where a longitudinal direction of the slicing table 472 is parallel to a center axis Ct2 direction of the monocrystal for slicing T2. A flat surface opposite the holding surface 473 of the slicing table 472 is fixed to the work plate 471.

The slicing device 4 rotates the plurality of main rollers 41 to move the wires 42 in a direction (right-left direction) that is roughly orthogonal to the axial directions of the main rollers 41, and lowers and presses the monocrystal for slicing T2 against the wire row while supplying the slurry G between the two upper main rollers 411, thereby slicing the monocrystal for slicing T2 to manufacture a plurality of the wafers W.

### Wafer Manufacturing Method

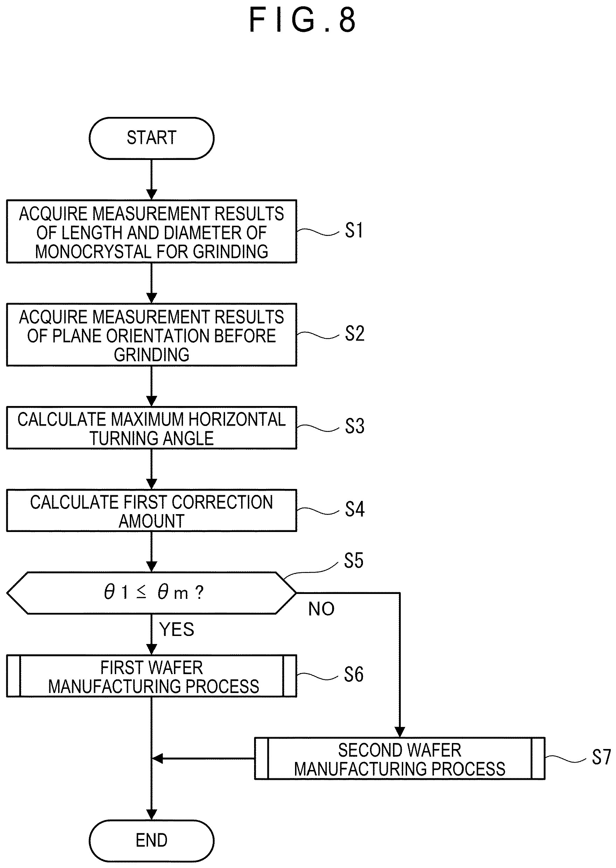

The wafer manufacturing method of the wafers W using the wafer manufacturing system 1 will be described next. Fig. 8 is a flowchart of the wafer manufacturing method.

Firstly, the cylindrical-shaped monocrystal for grinding T1 at which the temporary notch Nk has been formed is prepared.

Subsequently, as illustrated in Fig. 8, the measurement result acquiring section 364 of the cylindrical grinding apparatus 3 controls the length-measurement section 34 to acquire measurement results of the length L1 and the diameter R1 of the monocrystal for grinding T1 (Step S1).

Subsequently, the measurement result acquiring section 364 controls the orientation measuring section 33 to acquire measurement results of the plane orientation before grinding M1 of the monocrystal for grinding T1 (Step S2).

Further, the maximum horizontal turning angle computing section 365 calculates the maximum horizontal turning angle θm (Step S3).

Then, the correction amount computing section 366 calculates the first correction amount including the first rotation angle φ1 and the first horizontal turning angle θ1 (Step S4).

For instance, the correction amount computing section 366 obtains a deviation between the plane orientation before grinding M1 of the monocrystal for grinding T1 and the target plane orientation Mw when the monocrystal for grinding T1 is viewed from the center axis Ct1 direction (see an upper first-left diagram of Fig. 10). Subsequently, the correction amount computing section 366 calculates, as the first rotation angle φ1, an angle that enables values of the plane orientation before grinding M1 and the target plane orientation Mw in a vertical direction (Y-axis direction) to be equal to each other when the monocrystal for grinding T1 is rotated around the center axis Ct1, in a state where the monocrystal for grinding T1 is viewed from the center axis Ct1 direction (see an upper second-left diagram of Fig. 10). Further, the correction amount computing section 366 calculates, as the first horizontal turning angle θ1, an angle that enables values of the plane orientation before grinding M1 and the target plane orientation Mw in a horizontal direction (X-axis direction) to be equal to each other when the monocrystal for grinding T1 is horizontally turned around the vertical axis D1, in a state where the monocrystal for grinding T1 before the horizontal turning is viewed from the center axis Ct1 direction (see an upper third-left diagram of Fig. 10).

After Step S4, the grinding-possibility determining section 367 determines whether the first horizontal turning angle θ1 is equal to or less than the maximum horizontal turning angle θm (Step S5).

In a case where it is determined by the grinding-possibility determining section 367 that the first horizontal turning angle θ1 is equal to or less than the maximum horizontal turning angle θm (Step S5: YES), that is, it is determined to be possible to cylindrically grind the entire outer circumferential surface of the monocrystal for grinding T1 when the monocrystal for grinding T1 is horizontally turned by the first horizontal turning angle θ1, the cylindrical grinding apparatus 3 and the slicing device 4 perform a first wafer manufacturing process (Step S6).

On the other hand, in a case where it is determined by the grinding-possibility determining section 367 that the first horizontal turning angle θ1 exceeds the maximum horizontal turning angle θm (Step S5: NO), that is, it is determined to be impossible to cylindrically grind the entire outer circumferential surface of the monocrystal for grinding T1 when the monocrystal for grinding T1 is horizontally turned by the first horizontal turning angle θ1, the cylindrical grinding apparatus 3 and the slicing device 4 perform a second wafer manufacturing process (Step S7).

The wafers W having characteristics as illustrated in Fig. 1 are manufactured through the first wafer manufacturing process or the second wafer manufacturing process.

### First Wafer Manufacturing Process

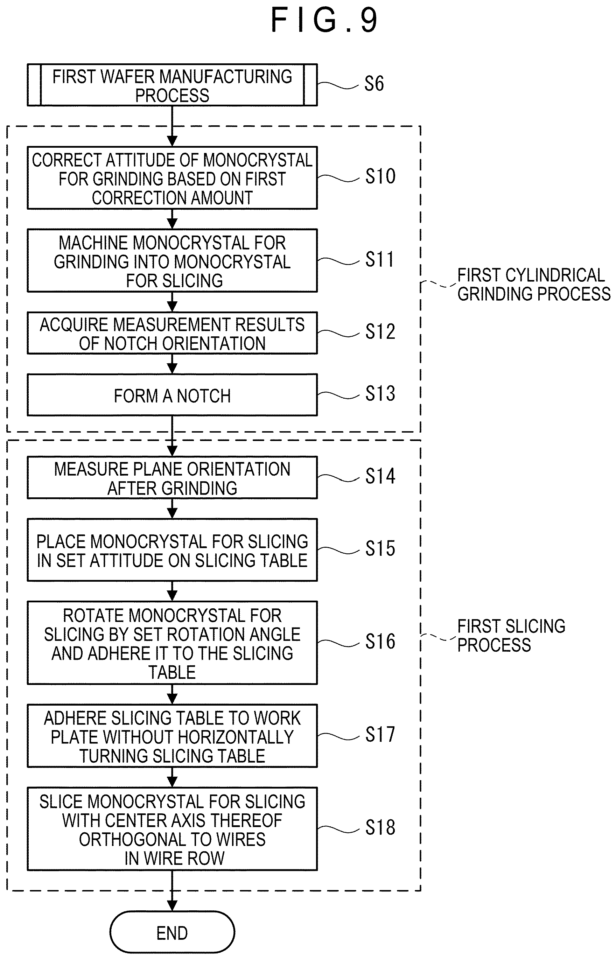

Details of the first wafer manufacturing process in Step S6 will be described next. Fig. 9 is a flowchart illustrating the first wafer manufacturing process. Fig. 10 is a schematic view illustrating an outline of the first wafer manufacturing process.

It should be noted that four upper diagrams illustrate a first cylindrical grinding process and four lower diagrams illustrate a first slicing process in Fig. 10.

In each of the upper first-left diagram to the upper third-left diagram of Fig. 10, an X axis represents a shift amount in the horizontal direction of the plane orientation from the center axis Ct1, and a Y axis represents a shift amount in the vertical direction of the plane orientation from the center axis Ct1, when the monocrystal for grinding T1 whose attitude has not been corrected is viewed from the center axis Ct1 direction. In an upper fourth-left diagram of Fig. 10, an X axis represents a shift amount in the horizontal direction of the plane orientation from the center axis Ct2, and a Y axis represents a shift amount in the vertical direction of the plane orientation from the center axis Ct2, when the monocrystal for slicing T2 is viewed from the center axis Ct2 direction.

In each of a lower first-left diagram to a lower third-left diagram of Fig. 10, an X axis represents a shift amount in the horizontal direction of the plane orientation from the center axis Ct2, and a Y axis represents a shift amount in the vertical direction of the plane orientation from the center axis Ct2, when the monocrystal for slicing T2 whose attitude has not been corrected is viewed from the center axis Ct2 direction. In a lower fourth-left diagram of Fig. 10, an X axis represents a shift amount in the horizontal direction of the plane orientation from the center axis Cw, and a Y axis represents a shift amount in the vertical direction of the plane orientation from the center axis Cw, when the wafer W is viewed from a center axis Cw direction.

The first wafer manufacturing process illustrated in Fig. 9 includes the first cylindrical grinding process consisting of Steps S10 to S13, and the first slicing process consisting of Steps S14 to S18.

In the first cylindrical grinding process, the monocrystal for grinding T1 is machined into the monocrystal for slicing T2 whose plane orientation after grinding M2 coincides with the target plane orientation Mw.

In the first slicing process, a plurality of the wafers W are manufactured using the monocrystal for slicing T2 whose plane orientation after grinding M2 coincides with the target plane orientation Mw.

The first cylindrical grinding process will be described first.

The attitude correcting section 38 of the cylindrical grinding apparatus 3 corrects the attitude of the monocrystal for grinding T1 on the basis of the first correction amount (Step S10).

For instance, the attitude correcting section 38 rotates the monocrystal for grinding T1 illustrated in the upper first-left diagram of Fig. 10 (the diagram of the monocrystal for grinding T1 before attitude change in the first cylindrical grinding process) by the first rotation angle φ1, thereby correcting the attitude of the monocrystal for grinding T1 to an attitude illustrated in the upper second-left diagram (the diagram of vertical direction correction in the first cylindrical grinding process). Subsequently, the attitude correcting section 38 horizontally turns the monocrystal for grinding T1 by the first horizontal turning angle θ1, thereby correcting the attitude of the monocrystal for grinding T1 to an attitude illustrated in the upper third-left diagram of Fig. 10 (the diagram of horizontal direction correction in the first cylindrical grinding process).

Then, the attitude correcting section 38 causes the pair of rotating-holding units 314 to hold the monocrystal for grinding T1, in a state where the center axis Ct1 is inclined at the first horizontal turning angle θ1 with respect to the rotation axis C, for instance, as illustrated in the topmost diagram of Fig. 6, and also the plane orientation before grinding M1 coincides with the target plane orientation Mw when the monocrystal for grinding T1 is viewed from a rotation axis C direction, as illustrated in the upper third-left diagram of Fig. 10.

After Step S10, as illustrated in Fig. 9, the grinding controller 369 controls the grinding section 31 to cylindrically grind the outer circumferential surface of the monocrystal for grinding T1 whose attitude has been corrected, so that the monocrystal for grinding T1 is machined into the monocrystal for slicing T2 (Step S11).

Subsequently, the measurement result acquiring section 364 controls the orientation measuring section 33 to acquire measurement results of the notch orientation of the monocrystal for grinding T2 (Step S12).

Then, the notch formation controller 370 controls the notch forming section 35 to form the notch N, which represents the plane orientation after grinding M2 of the monocrystal for slicing T2, at a position corresponding to the notch orientation at the monocrystal for slicing T2 (Step S13).

Through the first cylindrical grinding process (Steps S10 to S13) as described above, the monocrystal for slicing T2 whose plane orientation after grinding M2 coincides with the target plane orientation Mw is obtained, as illustrated in the upper fourth-left diagram of Fig. 10 (the diagram of the monocrystal for slicing T2 after the cylindrical grinding in the first cylindrical grinding process).

The first slicing process will be described next. It should be noted that Steps S15 to S17 may be performed by a processor or may be performed by a worker.

Firstly, as illustrated in Fig. 9, the plane orientation after grinding M2 of the monocrystal for slicing T2 is measured using a plane orientation measuring device (not illustrated) (Step S14).

The slicing table 472 is placed on the work plate 471 in a state where the holding surface 473 faces upward and longitudinal directions of the slicing table 472 and the work plate 471 are parallel to each other.

Subsequently, the monocrystal for slicing T2 is placed in a set attitude on the holding surface 473 of the slicing table 472 (Step S15). The set attitude in the exemplary embodiment refers to an attitude in which the notch N is positioned at a highest position, i.e., the notch N is positioned at the slicing start position P when the monocrystal for slicing T2 is viewed from the center axis Ct2 direction, as illustrated in the lower first-left diagram of Fig. 10 (the diagram of the monocrystal for slicing T2 before attitude change in the first slicing process).

Subsequently, the monocrystal for slicing T2 is rotated on the slicing table 472 by the set rotation angle φs around the center axis Ct2, thereby causing a relationship between the plane orientation after grinding M2 and the slicing start position P to be a specific relationship. The monocrystal for slicing T2 is then adhered to the slicing table 472 (Step S16).

Through Step S16, as illustrated in the lower second-left diagram of Fig. 10 (the diagram of vertical direction correction in the first slicing process), a positional relationship between the notch N, the plane orientation after grinding M2 and the slicing start position P when viewed from the center axis Ct2 direction is the same as a positional relationship between the notch N, the target plane orientation Mw and the slicing start position P when the wafer W is viewed from the center axis Cw direction as illustrated in Fig. 1.

Then, the slicing table 472 is adhered to the work plate 471, without horizontally turning the slicing table 472 with respect to the work plate 471 around a vertical axis, as a turn axis that is orthogonal to and intersects the center axis Ct1 of the monocrystal for slicing T2 (Step S17).

Through Step S17, the monocrystal for slicing T2 is fixed to the work plate 471 in a state where the center axis Ct2 and the longitudinal direction of the work plate 471 are parallel to each other. The attitude of the monocrystal for slicing T2 is unchanged before and after Step S17, as illustrated in the lower third-left diagram of Fig. 10 (the diagram of the monocrystal for slicing T2 without horizontal direction correction in the first slicing process).

Subsequently, the work plate 471 is fixed in a predetermined state to the lifting section 48, and the monocrystal for slicing T2 is sliced from the slicing start position P as a start point in a state where the center axis Ct2 of the monocrystal for slicing T2 is orthogonal to the wires 42 in the wire row (Step S18).

Through Step S18, a plurality of the wafers W can be obtained, in each of which the plane orientation coincides with the target plane orientation Mw, the relationship between the plane orientation and the slicing start position P is a specific relationship, and the generation state of waviness with respect to the plane orientation is constant, as illustrated in the lower fourth-left diagram of Fig. 10 (the diagram of the wafer W after the slicing in the first slicing process) and Fig. 1.

### Second Wafer Manufacturing Process

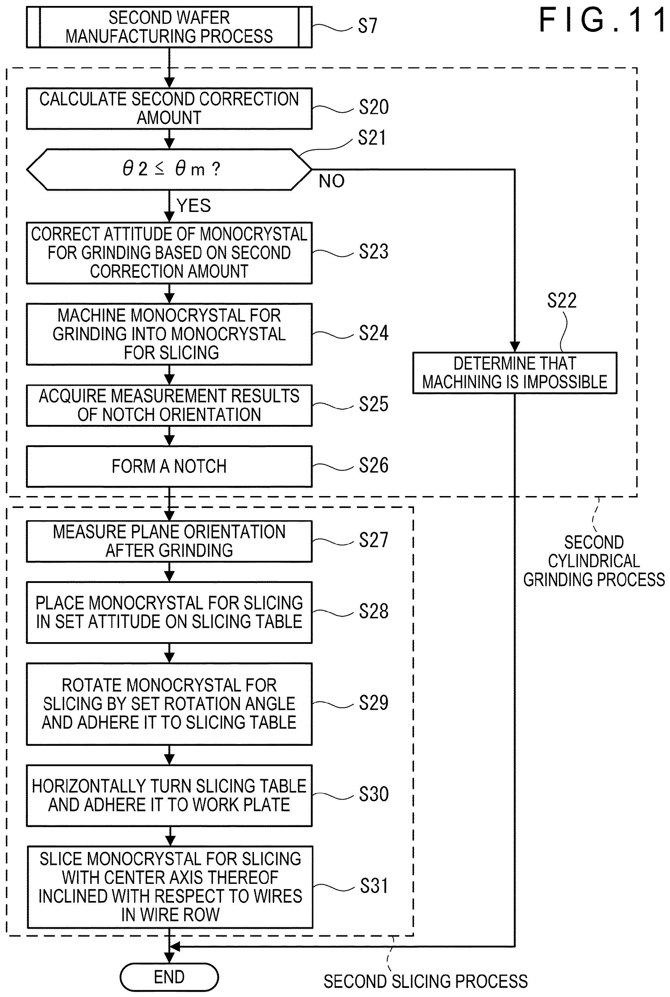

Details of the second wafer manufacturing process in Step S7 will be described next. Fig. 11 is a flowchart illustrating the second wafer manufacturing process. Fig. 12 is a schematic view illustrating an outline of the second wafer manufacturing process.

It should be noted that four upper diagrams in Fig. 12 illustrate a second cylindrical grinding process, and four lower diagrams illustrate a second slicing process.

The eight diagrams in Fig. 12 represent the same contents as those of the diagrams in Fig. 10 that are illustrated in the same locations, respectively.

The second wafer manufacturing process illustrated in Fig. 11 includes the second cylindrical grinding process consisting of Steps S20 to S26, and the second slicing process consisting of Steps S27 to S31.

In the second cylindrical grinding process, the monocrystal for grinding T1 is machined into the monocrystal for slicing T2 whose plane orientation after grinding M2 does not coincide with the target plane orientation Mw.

In the second slicing process, a plurality of the wafers W are manufactured using the monocrystal for slicing T2 whose plane orientation after grinding M2 does not coincide with the target plane orientation Mw.

The second cylindrical grinding process will be described first.

The correction amount computing section 366 calculates the second correction amount including the second rotation angle φ2 and the second horizontal turning angle θ2 (Step S20).

The correction amount computing section 366 sets, for instance, a linear correctable range K indicated by a broken line in a lower second-left diagram of Fig. 12 (the diagram of vertical direction correction in the second slicing process). The correctable range K is set so that the target plane orientation Mw is included in the correctable range K when the monocrystal for slicing T2 is viewed from the center axis Ct2 direction. In a case where the target plane orientation Mw and the plane orientation after grinding M2 are included in the correctable range K, the correctable range K is set to enable values in the vertical direction of the plane orientation after grinding M2 and the target plane orientation Mw to be equal to each other viewed from the center axis Ct2 direction, when the monocrystal for slicing T2 placed in the set attitude on the slicing table 472 is rotated by the set rotation angle φs around the center axis Ct2 (see the lower second-left diagram of Fig. 12), which will be described later in detail.

After setting the correctable range K, the correction amount computing section 366 obtains the deviation between the plane orientation before grinding M1 of the monocrystal for grinding T1 and the target plane orientation Mw when the monocrystal for grinding T1 is viewed from the center axis Ct1 direction (see an upper first-left diagram of Fig. 12). Subsequently, the correction amount computing section 366 calculates, as the second rotation angle φ2, an angle that enables the correctable range K including the target plane orientation Mw to be horizontal to the vertical direction, when the monocrystal for grinding T1 is rotated around the center axis Ct1, in a state where the monocrystal for grinding T1 is viewed from the center axis Ct1 direction (see an upper second-left diagram of Fig. 12). Further, the correction amount computing section 366 calculates, as the second horizontal turning angle θ2, an angle that enables the plane orientation before grinding M1 to be included in the correctable range K and not to coincide with the target plane orientation Mw, when the monocrystal for grinding T1 is horizontally turned around the vertical axis D1, in a state where the monocrystal for grinding T1 before the horizontal turning is viewed from the center axis Ct1 direction (see an upper third-left diagram of Fig. 12).

The second horizontal turning angle θ2 thus obtained is smaller than the first horizontal turning angle θ1. Accordingly, it is more likely to be determined, in Step S21 to be described later, that the entire outer circumferential surface of the monocrystal for grinding T1 can be cylindrically ground to have the target diameter R2, when the monocrystal for grinding T1 is horizontally turned by the second horizontal turning angle θ2.

After Step S20, the grinding-possibility determining section 367 determines whether the second horizontal turning angle θ2 is equal to or less than the maximum horizontal turning angle θm (Step S21).

When it is determined by the grinding-possibility determining section 367 that the second horizontal turning angle θ2 exceeds the maximum horizontal turning angle θm (Step S21: NO), that is, when it is determined to be impossible to cylindrically grind the entire outer circumferential surface of the monocrystal for grinding T1 when the monocrystal for grinding T1 is horizontally turned by the second horizontal turning angle θ2, it is determined that machining the monocrystal for grinding T1 into the monocrystal for slicing T2 is impossible (Step S22). After Step S22, the process is finished without manufacturing the wafers W from the monocrystal for grinding T1.

In contrast, when it is determined by the grinding-possibility determining section 367 that the second horizontal turning angle θ2 is equal to or less than the maximum horizontal turning angle θm (Step S21: YES), that is, when it is determined to be possible to cylindrically grind the entire outer circumferential surface of the monocrystal for grinding T1 when the monocrystal for grinding T1 is horizontally turned by the second horizontal turning angle θ2, the attitude correcting section 38 corrects the attitude of the monocrystal for grinding T1 on the basis of the second correction amount (Step S23).

For instance, the attitude correcting section 38 rotates the monocrystal for grinding T1 illustrated in the upper first-left diagram of Fig. 12 (the diagram of the monocrystal for grinding T1 before attitude change in the second cylindrical grinding process) by the second rotation angle φ2, thereby correcting the attitude of the monocrystal for grinding T1 to an attitude illustrated in the upper second-left diagram of Fig. 12 (the diagram of vertical direction correction in the second cylindrical grinding process). Subsequently, the attitude correcting section 38 horizontally turns the monocrystal for grinding T1 by the second horizontal turning angle θ2, thereby correcting the attitude of the monocrystal for grinding T1 to an attitude illustrated in the upper third-left diagram of Fig. 12 (the diagram of horizontal direction correction in the second cylindrical grinding process).

Then, the attitude correcting section 38 causes the pair of rotating-holding units 314 to hold the monocrystal for grinding T1, in a state where the center axis Ct1 is inclined at the second horizontal turning angle θ2 with respect to the rotation axis C, so that the plane orientation before grinding M1 and the target plane orientation Mw that are not coincident with each other are included in the correctable range K horizontal to the vertical direction, when the monocrystal for grinding T1 is viewed from the rotation axis C direction, as illustrated in the upper third-left diagram of Fig. 12.

After Step S23, as illustrated in Fig. 11, the grinding controller 369 performs a step similar to Step S11 to cylindrically grind the outer circumferential surface of the monocrystal for grinding T1 whose attitude has been corrected, so that the monocrystal for grinding T1 is machined into the monocrystal for slicing T2 (Step S24).

Subsequently, the measurement result acquiring section 364 performs a step similar to Step S12 to acquire measurement results of the notch orientation of the monocrystal for grinding T2 (Step S25).

Then, the notch formation controller 370 performs a step similar to Step S13 to form the notch N, which represents the plane orientation after grinding M2 of the monocrystal for slicing T2, at a position corresponding to the notch orientation at the monocrystal for slicing T2 (Step S26).

Through the second cylindrical grinding process (Steps S20 to S26) as described above, the monocrystal for slicing T2, in which the plane orientation before grinding M1 and the target plane orientation Mw not coincident with each other are included in the correctable range K, is obtained, as illustrated in the upper fourth-left diagram of Fig. 12 (the diagram of the monocrystal for slicing T2 after the cylindrical grinding in the second cylindrical grinding process).

The second slicing process will be described next. It should be noted that Steps S28 to S30 may be performed by a processor or may be performed by a worker.

Firstly, as in Step S14, the plane orientation after grinding M2 of the monocrystal for slicing T2 is measured, as illustrated in Fig. 11 (Step S27).

Also, as in the first slicing process, the slicing table 472 is placed on the work plate 471.

Subsequently, as in Step S15, the monocrystal for slicing T2 in the set attitude is placed on the slicing table 472 (Step S28).

Subsequently, as in Step S16, the monocrystal for slicing T2 is rotated on the slicing table 472 by the set rotation angle φs around the center axis Ct2, and is adhered to the slicing table 472 (Step S29).

Through Step S29, as illustrated in the lower second-left diagram of Fig. 12 (the diagram of vertical direction correction in the second slicing process), a positional relationship between the notch N and the slicing start position P viewed from the center axis Ct2 direction is the same as a positional relationship between the notch N and the slicing start position P when the wafer W is viewed from the center axis Cw direction as illustrated in Fig. 1. However, a positional relationship between the plane orientation after grinding M2 and the slicing start position P viewed from the center axis Ct2 direction is not the same as a positional relationship between the target plane orientation Mw and the slicing start position P when the wafer W is viewed from the center axis Cw direction as illustrated in Fig. 1. Further, the values in the vertical direction of the plane orientation after grinding M2 and the target plane orientation Mw viewed from the center axis Ct2 direction are equal to each other.

Then, the slicing table 472 is horizontally turned with respect to the work plate 471 around a vertical axis that is orthogonal to and intersects the center axis Ct2 of the monocrystal for slicing T2 so that the plane orientation after grinding M2 and the target plane orientation Mw coincide with each other when viewed from the center axis Ct2 direction, and the slicing table 472 is adhered to the work plate 471 (Step S30).

Through Step S30, the monocrystal for slicing T2 is fixed to the work plate 471 in a state where the center axis Ct2 is inclined with respect to the longitudinal direction of the work plate 471. The attitude of the monocrystal for slicing T2 after Step S30 is different from that before Step S30, as illustrated in the lower third-left diagram of Fig. 12 (the diagram of the monocrystal for slicing T2 with horizontal direction correction in the second slicing process).

Subsequently, as in Step S17, the work plate 471 is fixed in a predetermined state to the lifting section 48, and the monocrystal for slicing T2 is sliced from the slicing start position P as a start point in a state where the center axis Ct2 of the monocrystal for slicing T2 is inclined with respect to the wires 42 in the wire row (Step S31).

Through Step S31, a plurality of the wafers W can be obtained, in each of which the plane orientation coincides with the target plane orientation Mw, the relationship between the plane orientation and the slicing start position P is a specific relationship, and the generation state of waviness with respect to the plane orientation is constant, as illustrated in the lower fourth-left diagram of Fig. 12 (the diagram of the wafer W after the slicing in the second slicing process) and Fig. 1.

### Effects of Exemplary Embodiment(s)

According to the above-described exemplary embodiment, the cylindrical grinding apparatus 3 includes the attitude correcting section 38 and the grinding section 31. The attitude correcting section 38 corrects the attitude of the monocrystal for grinding T1 to incline the center axis Ct1 with respect to the rotation axis C, by performing the rotation process and the horizontal turn process on the monocrystal for grinding T1 on the basis of the plane orientation difference between the plane orientation before grinding M1 of the monocrystal for grinding T1 and the target plane orientation Mw of the wafer W. The grinding section 31 cylindrically grinds the outer circumferential surface of the monocrystal for grinding T1 whose attitude has been corrected.

Thus, a deviation between the plane orientation after grinding M2 of the monocrystal for slicing T2, which is obtained from the monocrystal for grinding T1 having any plane orientation before grinding M1, and the target plane orientation Mw can be controlled into a predetermined state by the cylindrical grinding. Consequently, a plurality of the wafers W, in each of which the relationship between the plane orientation and the slicing start position P is a specific relationship and the generation state of waviness with respect to the plane orientation is constant, can be obtained, by slicing the monocrystal for slicing T2 after rotating the monocrystal for slicing T2 by the set rotation angle φs so that the relationship between the plane orientation after grinding M2 and the slicing start position P is a predetermined relationship, and horizontally turning the monocrystal for slicing T2 as needed. In other words, the cylindrical grinding apparatus 3 can be provided that is capable of producing, from the monocrystal for grinding T1 having any plane orientation before grinding M1, the monocrystal for slicing T2 from which a plurality of the wafers W with the constant generation state of waviness with respect to the plane orientation is obtainable.

The attitude correcting section 38 includes the attitude correction controller 368. The attitude correction controller 368 controls the rotation section 311 to hold the monocrystal for grinding T1 and performs the rotation process in a state where the center axis Ct1 is coincident with the rotation axis C, and controls the horizontal turn section 32 to receive the monocrystal for grinding T1 from the rotation section 311, perform the horizontal turn process, and then return the monocrystal for grinding T1 to the rotation section 311.

As described above, since the rotation section 311 for rotating the monocrystal for grinding T1 is used as a configuration for correcting the attitude of the monocrystal for grinding T1 in the cylindrical grinding, it is possible to prevent the configuration of the cylindrical grinding apparatus 3 from being complicated.

The correction amount computing section 366 obtains the first rotation angle φ1 and the first horizontal turning angle θ1 that enable the plane orientation after grinding M2 of the monocrystal for slicing T2 to coincide with the target plane orientation Mw. After the attitude correcting section 38 rotates the monocrystal for grinding T1 by the first rotation angle φ1 and also horizontally turns the monocrystal for grinding T1 by the first horizontal turning angle θ1, the grinding section 31 cylindrically grinds the outer circumferential surface of the monocrystal for grinding T1. The cylindrical grinding apparatus 3 thus performs the first cylindrical grinding process in which the monocrystal for grinding T1 is machined into the monocrystal for slicing T2 whose plane orientation after grinding M2 coincides with the target plane orientation Mw.

Since the wafers W are manufactured by using the monocrystal for slicing T2 having the plane orientation after grinding M2 coincident with the target plane orientation Mw as described above, a plurality of the wafers W having the constant generation state of waviness with respect to the plane orientation can be obtained without horizontally turning the monocrystal for slicing T2. Consequently, it is possible to prevent the number of processes included in the slicing process from increasing.

The grinding-possibility determining section 367 determines whether it is possible to cylindrically grind the entire outer circumferential surface of the monocrystal for grinding T1 that has been horizontally turned by the first horizontal turning angle θ1, on the basis of the length L1 and the diameter R1 of the monocrystal for grinding T1 and the target diameter R2 of the monocrystal for slicing T2. Subsequently, when it is determined to be possible to cylindrically grind the entire outer circumferential surface of the monocrystal for grinding T1 that has been horizontally turned by the first horizontal turning angle θ1, the attitude correcting section 38 and the grinding section 31 perform the first cylindrical grinding process. On the other hand, when it is determined to be impossible to cylindrically grind the entire outer circumferential surface of the monocrystal for grinding T1, the attitude correcting section 38 and the grinding section 31 do not perform the first cylindrical grinding process.

If the monocrystal for slicing T2 a part of which is not cylindrically ground is sliced, the manufactured wafers W are not disk-shaped.

In the exemplary embodiment, the first cylindrical grinding process is performed only when the cylindrical grinding can be performed on the entire outer circumferential surface of the monocrystal for grinding T1 that has been horizontally turned by the first horizontal turning angle θ1, which can prevent the wafers W that are not disk-shaped from being manufactured.

The correction amount computing section 366 obtains the second rotation angle φ2 and the second horizontal turning angle θ2, when it is determined to be impossible to cylindrically grind the entire outer circumferential surface of the monocrystal for grinding T1. The second horizontal turning angle θ2 is smaller than the first horizontal turning angle θ1. The second rotation angle φ2 and the second horizontal turning angle θ2 do not enable the plane orientation after grinding M2 of the monocrystal for slicing T2 to coincide with the target plane orientation Mw. However, by rotating the monocrystal for slicing T2, in which the relationship between the plane orientation after grinding M2 and the slicing start position P is a predetermined relationship, by the set rotation angle φs around the center axis Ct2, and also horizontally turning the monocrystal for slicing T2 around the vertical axis orthogonal to the center axis Ct2, the second rotation angle φ2 and the second horizontal turning angle θ2 enable the plane orientation after grinding M2 of the monocrystal for slicing T2 to coincide with the target plane orientation Mw, when viewed from the center axis Ct2 direction before the horizontal turning. After the attitude correcting section 38 rotates the monocrystal for grinding T1 by the second rotation angle φ2 and also horizontally turns the monocrystal for grinding T1 by the second horizontal turning angle θ2, the grinding section 31 cylindrically grinds the outer circumferential surface of the monocrystal for grinding T1. The cylindrical grinding apparatus 3 thus performs the second cylindrical grinding process in which the monocrystal for grinding T1 is machined into the monocrystal for slicing T2 whose plane orientation after grinding M2 does not coincide with the target plane orientation Mw.

As described above, when the cylindrical grinding cannot be performed on the entire outer circumferential surface of the monocrystal for grinding T1 that has been horizontally turned by the first horizontal turning angle θ1, the monocrystal for slicing T2 whose plane orientation after grinding M2 does not coincide with the target plane orientation Mw is used for manufacturing the wafers W. In this case, by horizontally turning the monocrystal for slicing T2, a plurality of the wafers W having the constant generation state of waviness with respect to the plane orientation can be obtained.

The grinding-possibility determining section 367 determines whether it is possible to cylindrically grind the entire outer circumferential surface of the monocrystal for grinding T1 that has been horizontally turned by the second horizontal turning angle θ2. Subsequently, when it is determined to be possible to cylindrically grind the entire outer circumferential surface of the monocrystal for grinding T1 horizontally turned by the second horizontal turning angle θ2, the attitude correcting section 38 and the grinding section 31 perform the second cylindrical grinding process. On the other hand, when it is determined to be impossible to cylindrically grind the entire outer circumferential surface of the monocrystal for grinding T1, the attitude correcting section 38 and the grinding section 31 do not perform the second cylindrical grinding process.

As described above, the second cylindrical grinding process is performed only when the cylindrically grinding can be performed on the entire outer circumferential surface of the monocrystal for grinding T1 that has been horizontally turned by the second horizontal turning angle θ2, which can prevent the wafers W that are not disk-shaped from being manufactured.

### Modifications

Although the exemplary embodiment of the invention has been described above with reference to the attached drawings, a specific configuration is not limited to the exemplary embodiment, and various improvements and changes in designs that do not depart from the gist of the invention are included in the invention.

### First Modification

When the notch formation controller 370 controls the notch forming section 35 to form the notch N in Step S13, it is preferable to select the formation position of the notch N so that the first horizontal turning angle θ1 is minimized.

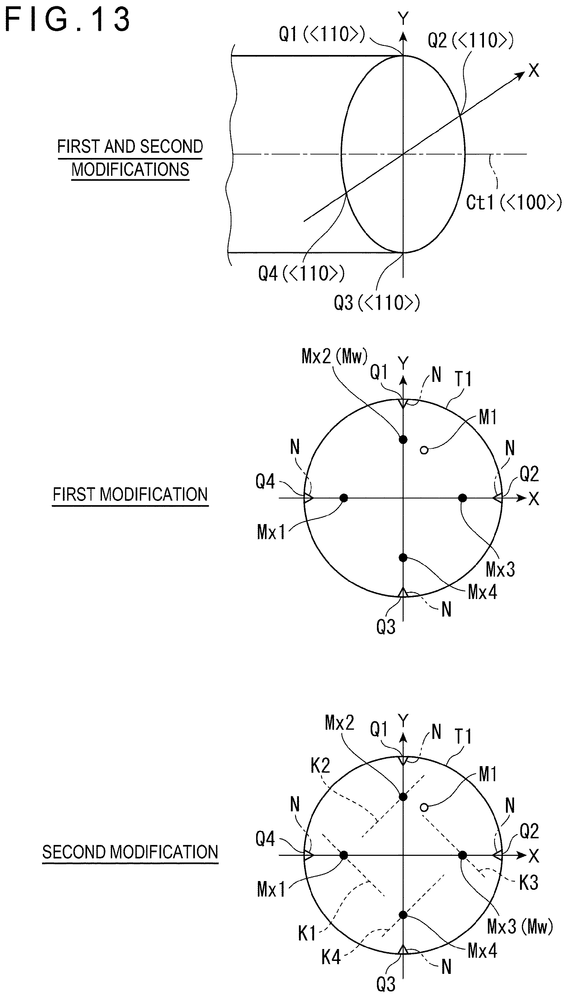

Specifically, the notch N is formed in accordance with crystal axes on the outer circumferential surface of the monocrystal for grinding T1. For instance, when the monocrystal for grinding T1 has the center axis Ct1 whose crystal orientation is <100>, there are four crystal axes each having a crystal orientation of <110> at intervals of 90 degrees in a circumferential direction on the outer circumferential surface of the monocrystal for grinding T1, as illustrated in a first top diagram of Fig. 13. The four crystal axes serve as candidate positions for forming the notch N (hereinafter, the four candidate positions are occasionally referred to as a "first notch forming candidate position Q1", "second notch forming candidate position Q2", "third notch forming candidate position Q3", and "fourth notch forming candidate position Q4", respectively).

The plane orientation is represented by the position of the notch N. Thus, if there are the four notch forming candidate positions, the plane orientation is also represented in four ways accordingly. Namely, a first temporary target plane orientation Mx1 when the notch N is formed at the first notch forming candidate position Q1, a second temporary target plane orientation Mx2 when the notch N is formed at the second notch forming candidate position Q2, a third temporary target plane orientation Mx3 when the notch N is formed at the third notch forming candidate position Q3, and a fourth temporary target plane orientation Mx4 when the notch N is formed at the fourth notch forming candidate position Q4 are represented, as illustrated in a second top diagram of Fig. 13.

When the plane orientation before grinding M1 of the monocrystal for grinding T1 is represented as illustrated in the second top diagram of Fig. 13, the second temporary target plane orientation Mx2 has the smallest deviation from the plane orientation before grinding M1, of the first to fourth temporary target plane orientations Mx1 to Mx4. In other words, when the second temporary target plane orientation Mx2 is set as the target plane orientation Mw, the first horizontal turning angle θ1 is minimized.

Thus, it is preferable that the notch formation controller 370 selects a position corresponding to the second notch forming candidate position Q2 at the monocrystal for slicing T2, as the formation position of the notch N, and performs control for forming the notch N at the selected position. In addition, the correction amount computing section 366 preferably obtains the first rotation angle φ1 and the first horizontal turning angle θ1 in Step S4 after the second temporary target plane orientation Mx2, which allows the first horizontal turning angle θ1 to be minimized, is set as the target plane orientation Mw.

Since the formation position of the notch N is selected so that the first horizontal turning angle θ1 is minimized as described above, the number of the wafers W having non-disk shape obtained from the monocrystal for slicing T2 can be decreased.

### Second Modification

For instance, when the notch formation controller 370 controls the notch forming section 35 to form the notch N in Step S26, it is preferable to select the formation position of the notch N so that the second horizontal turning angle θ2 is minimized. As described in the first modification, for instance, when the monocrystal for grinding T1 has the center axis Ct1 whose crystal orientation is <100>, the four crystal axes each having a crystal orientation of <110> serve as the first to fourth notch forming candidate positions Q1 to Q4.

The first to fourth temporary target plane orientations Mx1 to Mx4 when the notch N is formed at the first to fourth notch forming candidate positions Q1 to Q4, respectively, are represented as illustrated in a third top diagram of Fig. 13. Further, first, second, third and fourth temporary correctable ranges K1, K2, K3 and K4 respectively corresponding to the first, second, third and fourth temporary target plane orientations Mx1, Mx2, Mx3 and Mx4 are set, as illustrated in the third top diagram of Fig. 13.

When the plane orientation before grinding M1 of the monocrystal for grinding T1 is represented as illustrated in the third top diagram of Fig. 13, the third temporary correctable range K3 has the smallest deviation from the plane orientation before grinding M1, of the first to fourth temporary correctable ranges K1 to K4. In other words, when the third temporary target plane orientation Mx3 corresponding to the third temporary correctable range K3 is set as the target plane orientation Mw, the second horizontal turning angle θ2 is minimized.

Thus, it is preferable that the notch formation controller 370 selects a position corresponding to the third notch forming candidate position Q3 at the monocrystal for slicing T2, as the formation position of the notch N, and performs control for forming the notch N at the selected position. In addition, the correction amount computing section 366 preferably obtains the second rotation angle φ2 and the second horizontal turning angle θ2 in Step S20 after the third temporary target plane orientation Mx3, which allows the second horizontal turning angle θ2 to be minimized, is set as the target plane orientation Mw.

Since the formation position of the notch N is selected so that the second horizontal turning angle θ2 is minimized as described above, the number of the wafers W having non-disk shape obtained from the monocrystal for slicing T2 can be decreased.

### Other Modifications

The rotation section 311 is used as the configuration for correcting the attitude of the monocrystal for grinding T1. However, the cylindrical grinding apparatus 3 may be provided with another configuration for rotating the monocrystal for grinding T1 for the attitude correction.

An arrangement is exemplified in which, when the first horizontal turning angle θ1 exceeds the maximum horizontal turning angle θm, the first cylindrical grinding process is not performed. However, the first cylindrical grinding process may be performed regardless of the magnitude relationship between the first horizontal turning angle θ1 and the maximum horizontal turning angle θm, or the first cylindrical grinding process may be performed with an input operation by a worker through the input section 361 serving as a trigger.

An arrangement is exemplified in which, when the first horizontal turning angle θ1 exceeds the maximum horizontal turning angle θm, the second cylindrical grinding process is performed on the basis of a magnitude relationship between the second horizontal turning angle θ2 and the maximum horizontal turning angle θm. However, it may be determined that machining the monocrystal for grinding T1 into the monocrystal for slicing T2 is impossible.

An arrangement is exemplified in which, when the second horizontal turning angle θ2 exceeds the maximum horizontal turning angle θm, the second cylindrical grinding process is not performed. However, the second cylindrical grinding process may be performed regardless of the magnitude relationship between the second horizontal turning angle θ2 and the maximum horizontal turning angle θm.

When the first horizontal turning angle θ1 is equal to or less than the maximum horizontal turning angle θm, the second cylindrical grinding process may be performed instead of the first cylindrical grinding process.

### Example(s)

Example of the invention will be described next. It should be noted that the invention is not limited to Example.

A simulation is performed to check a percentage of successfully manufacturing a plurality of the wafers W (hereinafter, occasionally referred as "target wafers W'), each of which has the plane orientation coinciding with the target plane orientation Mw and the constant generation state of waviness with respect to the plane orientation, from the monocrystal for grinding T1 having any plane orientation before grinding M1, in the wafer manufacturing method of Example of the invention and that of Comparative.

### Wafer Manufacturing Method of Example

The wafer manufacturing method of Example will be described first.

The wafer manufacturing method of Example is the wafer manufacturing method of the above exemplary embodiment illustrated in Figs. 8 to 12, and includes a cylindrical grinding method of the invention (the first cylindrical grinding process and the second cylindrical grinding process of the above exemplary embodiment).

### Wafer Manufacturing Method of Comparative

The wafer manufacturing method of Comparative will be described next.

The wafer manufacturing method of Comparative does not include the cylindrical grinding method of the invention. In a cylindrical grinding method in the wafer manufacturing method of Comparative, the cylindrical grinding is performed on any monocrystal for grinding T1 in a state where the center axis Ct1 is coincident with the rotation axis C of a cylindrical grinding apparatus, regardless of the plane orientation difference between the plane orientation before grinding M1 and the target plane orientation Mw, and thereby the monocrystal for grinding T1 is machined into the monocrystal for slicing T2. Then, the notch N representing the plane orientation after grinding M2 is formed at the monocrystal for slicing T2.

In a slicing method in the wafer manufacturing method of Comparative, the monocrystal for slicing T2 in the set attitude is rotated on the slicing table 472 by the set rotation angle φs, as in Steps S15 and S16 of the above exemplary embodiment.

When the values in the horizontal direction of the plane orientation after grinding M2 of the monocrystal for slicing T2 after the rotation and the target plane orientation Mw are equal to each other, a step similar to Step S18 of the above exemplary embodiment is performed, in which the monocrystal for slicing T2 is sliced in a state where the center axis Ct2 is orthogonal to the wires 42 in the wire row.

Here, even when the values in the horizontal direction of the plane orientation after grinding M2 after the rotation and the target plane orientation Mw are equal to each other, the values in the vertical direction thereof are sometimes equal to and sometimes different from each other depending on the plane orientation before grinding M1 of the monocrystal for grinding T1. When the values in the horizontal direction of the plane orientation after grinding M2 and the target plane orientation Mw are equal to each other, the target wafers W can be obtained. However, when the values in the horizontal direction are different from each other, the target wafers W cannot be obtained.

In contrast, when the values in the horizontal direction of the plane orientation after grinding M2 after the rotation and the target plane orientation Mw are different from each other, a step similar to Step S30 of the above exemplary embodiment is performed, in which the slicing table 472 is horizontally turned around the vertical axis and is adhered to the work plate 471 so that the values in the horizontal direction of the plane orientation after grinding M2 and the target plane orientation Mw coincide with each other when viewed from the center axis Ct2 direction. Then, a step similar to Step S31 of the above exemplary embodiment is performed, in which the monocrystal for slicing T2 is sliced in a state where the center axis Ct2 is inclined with respect to the wires 42 in the wire row.

Here, even when the values in the horizontal direction of the plane orientation after grinding M2 after the horizontal turning and the target plane orientation Mw are equal to each other, the values in the vertical direction thereof are sometimes equal to and sometimes different from each other depending on the plane orientation before grinding M1 of the monocrystal for grinding T1. When the values in the vertical direction of the plane orientation after grinding M2 and the target plane orientation Mw are equal to each other, the target wafers W can be obtained. However, when the values in the vertical direction are different from each other, the target wafers W cannot be obtained.

### Simulation Method

The simulation method will be described next.

Conditions for the simulation were set as follows.
· Target plane orientation Mw: X = 0.30 degrees, Y = 0.00 degrees · Set rotation angle φs: 45 degrees
· Maximum horizontal turning angle θm: 0.5 degrees or less · Crystal orientation of center axis Ct1: <100>
· Crystal orientation of notch forming candidate position: <110>

The simulation was performed as to whether the target wafers W can be manufactured from 1,000 pieces of monocrystal for grinding T1, using the wafer manufacturing method of Comparative or Example. In the 1,000 pieces of the monocrystal for grinding T1, at least one of the values in the horizontal direction (X direction) of the plane orientation or the values in the vertical direction (Y direction) of the plane orientation were different from each other, with the center axis Ct1 viewed from the center axis Ct1 direction serving as a reference. The formation position of the notch N at the monocrystal for slicing T2 was selected so that the first horizontal turning angle θ1 or the second horizontal turning angle θ1 was minimized.

### Simulation Results and Consideration

The simulation results will be described next.

As shown in Table 1 below, an acceptance rate (probability of manufacturing the target wafers W) was 18.9 % in the wafer manufacturing method of Comparative, whereas the acceptance rate was 99.9 % in the wafer manufacturing method of Example.

**Table 1**

| | Comparative | Example |
|---|---|---|
| Number of Samples | 1000 | 1000 |
| Number of Acceptance | 189 | 951(First Wafer Manufacturing Process) |
| | | 48(Second Wafer Manufacturing Process) |
| Total Number of Acceptance | 189 | 999 |
| Acceptance Rate | 18.9% | 99.9% |

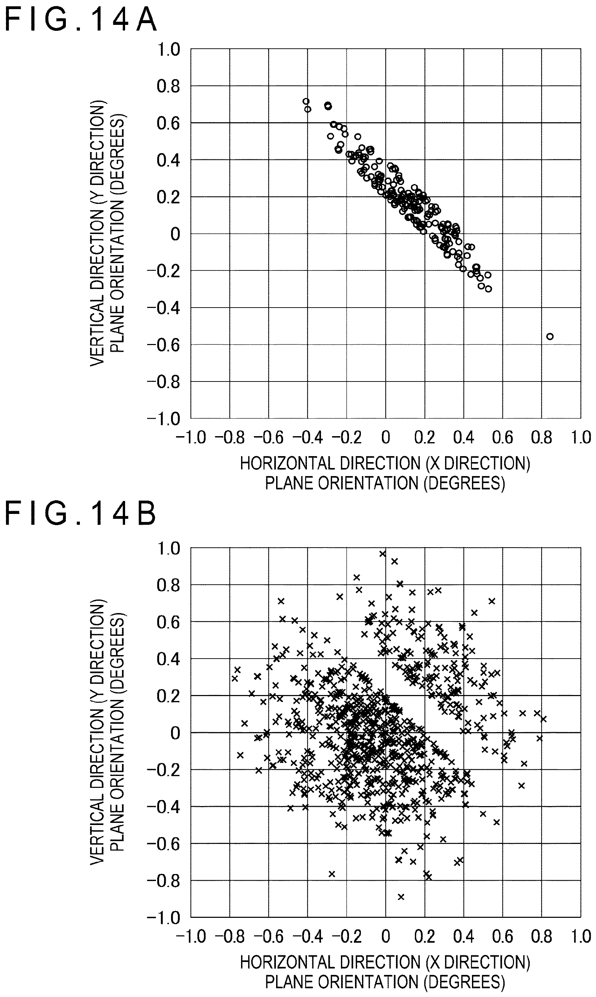

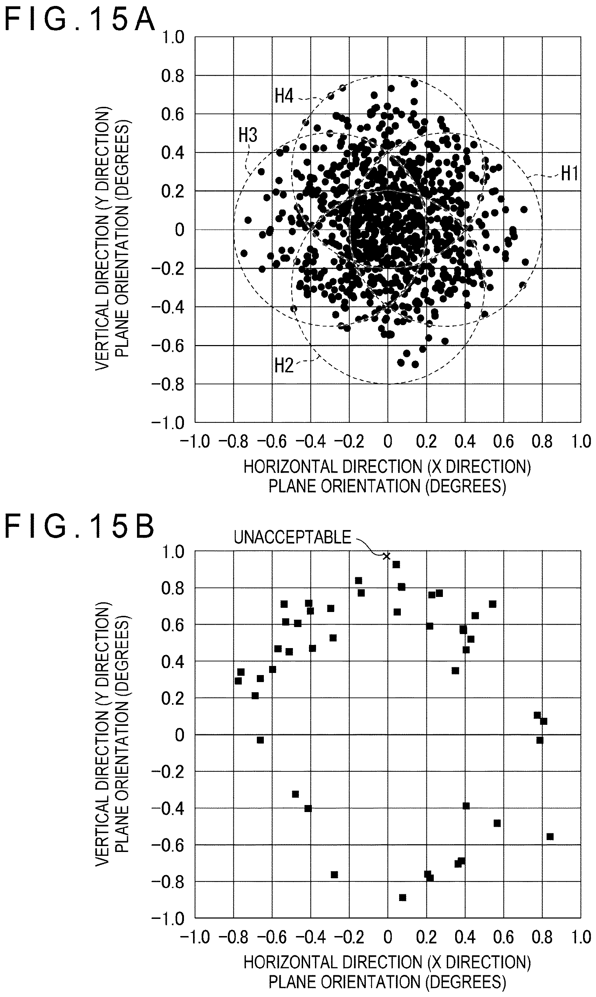

Details of the simulation results will be described next. Fig. 14A is a view in a form of graph illustrating the simulation results for the wafer manufacturing method of Comparative, which represents the plane orientations of pieces of the monocrystal for grinding from which the target wafers were manufactured. Fig. 14B is a view in a form of graph illustrating the simulation results for the wafer manufacturing method of Comparative, which represents the plane orientations of pieces of the monocrystal for grinding from which the target wafers were not manufactured. Fig. 15A is a view in a form of graph illustrating the simulation results for the wafer manufacturing method of Example, which represents the plane orientations of pieces of the monocrystal for grinding from which the wafers were manufactured through the first wafer manufacturing process. Fig. 15B is a view in a form of graph illustrating the simulation results for the wafer manufacturing method of Example, which represents the plane orientations of pieces of the monocrystal for grinding from which the target wafers were manufactured and the plane orientation of a piece of the monocrystal for grinding from which the target wafers were not manufactured, through the second wafer manufacturing process.

In the wafer manufacturing method of Comparative, some pieces of the monocrystal for grinding T1 were acceptable that had the values of the plane orientations before grinding M1 in the horizontal direction and the vertical direction included in a predetermined range inclined at an angle corresponding to the set rotation angle φs, in coordinate systems illustrated in Figs. 14A and 14B. However, the other pieces of the monocrystal for grinding T1 were unacceptable.

In contrast, in the wafer manufacturing method of Example, almost all pieces of the monocrystal for grinding T1 were acceptable regardless of the plane orientations before grinding M1, as illustrated in Figs. 15A and 15B.

In particular, the pieces of the monocrystal for grinding T1, which had the values of the plane orientations before grinding M1 in the horizontal direction and the vertical direction included in four circular ranges H1, H2, H3 and H4 in a coordinate system illustrated in Fig. 15A, were acceptable through the first wafer manufacturing process. As described above, for the monocrystal for grinding T1 whose center axis Ct1 has a crystal orientation of <100>, there are the four notch forming candidate positions. The centers (X, Y) of the circular ranges H1, H2, H3 and H4 are respectively (0.30 degrees, 0.00 degrees), (0.00 degrees, -0.30 degrees), (-0.30 degrees, 0.00 degrees), and (0.00 degrees, 0.30 degrees) corresponding to the target plane orientation Mw. Further, a radius of each of the circular ranges H1, H2, H3 and H4 is 0.5 degrees corresponding to the maximum horizontal turning angle θm.

That is, Fig. 15A indicates that the target wafers W can be manufactured from the monocrystal for grinding T1 by selecting, from among a plurality of notch forming candidate positions, the formation position of the notch N at the monocrystal for slicing T2 so that the first horizontal turning angle θ1 is minimized, in the first wafer manufacturing process.

Pieces of the monocrystal for grinding T1 having the values of the plane orientations before grinding M1 in the horizontal direction and the vertical direction that were not included in the four circular ranges H1 to H4, or pieces of the monocrystal for grinding T1 having the values of the plane orientations before grinding M1 in the horizontal direction and the vertical direction that were included in an outer peripheral area of the four circular ranges H1 to H4 were acceptable through the second wafer manufacturing process, except for one piece.

It was confirmed from the above results that, from the monocrystal for grinding T1 having any plane orientation before grinding M1, a plurality of the wafers W, each of which has a plane orientation coinciding with the target plane orientation Mw and the constant generation state of waviness with respect to the plane orientation, can be manufactured by using the wafer manufacturing method including the cylindrical grinding method of the invention.

### EXPLANATION OF CODES

3...cylindrical grinding apparatus, 31...grinding section, 311...rotation section, 313... relative movement section, 317...grinding member, 32... horizontal turn section, 35...notch forming section, 36... grinding controller, 38...attitude correcting section, 366... correction amount computing section, 367... grinding-possibility determining section, 368... attitude correction controller, 370... notch formation controller, C...rotation axis, Ct1, Ct2, Cw... center axis, M1... plane orientation before grinding, M2... plane orientation after grinding, Mw...target plane orientation, N... notch, P... slicing start position, T1... monocrystal for grinding, T2... monocrystal for slicing, W...wafer.

## Claims

1. A cylindrical grinding apparatus configured to produce a monocrystal for slicing by performing cylindrical grinding, in the cylindrical grinding an outer circumferential surface of a monocrystal for grinding being ground while the monocrystal for grinding is rotated around a rotation axis, the cylindrical grinding apparatus comprising:
an attitude correcting section configured to correct an attitude of the monocrystal for grinding to incline a center axis of the monocrystal for grinding with respect to the rotation axis, by performing a rotation and a turn based on a plane orientation difference between a plane orientation of the monocrystal for grinding and a target plane orientation of a wafer to be obtained by slicing the monocrystal for slicing, in the rotation the monocrystal for grinding being rotated around the center axis, in the turn the monocrystal for grinding being turned around a turn axis orthogonal to the center axis; and
a grinding section configured to cylindrically grind the outer circumferential surface of the monocrystal for grinding while rotating the monocrystal for grinding whose attitude has been corrected around the rotation axis.

2. The cylindrical grinding apparatus according to claim 1, wherein
the grinding section includes
a rotation section configured to hold and rotate the monocrystal for grinding around the rotation axis,
a grinding member configured to grind the outer circumferential surface of the monocrystal for grinding, and
a relative movement section configured to relatively move the rotation section and the grinding member along the rotation axis, and
the attitude correcting section includes
a turn section configured to perform the turn, and
an attitude correction controller configured to control the rotation section to hold the monocrystal for grinding and perform the rotation in a state where the center axis is coincident with the rotation axis, and to control the turn section to receive the monocrystal for grinding from the rotation section, perform the turn, and then return the monocrystal for grinding to the rotation section.

3. The cylindrical grinding apparatus according to claim 2, further comprising:
a correction amount computing section configured to obtain a first rotation angle for the rotation and a first turning angle for the turn, based on the plane orientation difference, wherein
the first rotation angle and the first turning angle enable a plane orientation of the monocrystal for slicing to coincide with the target plane orientation, and
the cylindrical grinding apparatus is configured to perform first cylindrical grinding to produce the monocrystal for slicing whose plane orientation coincides with the target plane orientation, in the first cylindrical grinding the attitude correcting section performing the rotation based on the first rotation angle and the turn based on the first turning angle, and then the grinding section cylindrically grinding the outer circumferential surface of the monocrystal for grinding whose attitude has been corrected by the attitude correcting section.

4. The cylindrical grinding apparatus according to claim 3, further comprising:
a grinding-possibility determining section configured to determine whether it is possible to cylindrically grind an entire outer circumferential surface of the monocrystal for grinding that has been turned by the first turning angle, based on a length and a diameter of the monocrystal for grinding and a target diameter of the monocrystal for slicing.

5. The cylindrical grinding apparatus according to claim 4, wherein
when the grinding-possibility determining section determines that it is possible to cylindrically grind the entire outer circumferential surface of the monocrystal for grinding that has been turned by the first turning angle, the cylindrical grinding apparatus is configured to perform the first cylindrical grinding.

6. The cylindrical grinding apparatus according to claim 5, wherein
when the grinding-possibility determining section determines that it is impossible to cylindrically grind the entire outer circumferential surface of the monocrystal for grinding that has been turned by the first turning angle, the correction amount computing section is configured to obtain a second rotation angle for the rotation and a second turning angle for the turn based on the plane orientation difference, the second turning angle being smaller than the first turning angle,
the second rotation angle and the second turning angle do not enable the plane orientation of the monocrystal for slicing to coincide with the target plane orientation, and by rotating the monocrystal for slicing, in which a relationship between the plane orientation and a slicing start position is a predetermined relationship, by a set rotation angle around the center axis and then turning the monocrystal for slicing around the turn axis orthogonal to the center axis, the second rotation angle and the second turning angle enable the plane orientation of the monocrystal for slicing to coincide with the target plane orientation when viewed from a direction of the center axis before turning the monocrystal for slicing, and
the cylindrical grinding apparatus is configured to perform second cylindrical grinding to produce the monocrystal for slicing whose plane orientation does not coincide with the target plane orientation, in the second cylindrical grinding the attitude correcting section performing the rotation based on the second rotation angle and the turn based on the second turning angle, and then the grinding section cylindrically grinding the outer circumferential surface of the monocrystal for grinding whose attitude has been corrected by the attitude correcting section.

7. The cylindrical grinding apparatus according to claim 6, wherein
the grinding-possibility determining section is configured to determine whether it is possible to cylindrically grind the entire outer circumferential surface of the monocrystal for grinding that has been turned by the second turning angle, based on the length and the diameter of the monocrystal for grinding and the target diameter of the monocrystal for slicing.

8. The cylindrical grinding apparatus according to claim 7, wherein
the cylindrical grinding apparatus is configured to perform the second cylindrical grinding when the grinding-possibility determining section determines that it is possible to cylindrically grind the entire outer circumferential surface of the monocrystal for grinding that has been turned by the second turning angle, and
the cylindrical grinding apparatus is configured not to perform the second cylindrical grinding when the grinding-possibility determining section determines that it is impossible to cylindrically grind the entire outer circumferential surface of the monocrystal for grinding that has been turned by the second turning angle.

9. The cylindrical grinding apparatus according to any one of claims 1 to 8, further comprising:
a notch forming section configured to form a notch at the monocrystal for slicing, the notch representing the target plane orientation.

10. The cylindrical grinding apparatus according to any one of claims 3 to 5, further comprising:
a notch formation controller configured to select, of a plurality of notch forming candidate positions representing the target plane orientation, a notch forming candidate position that allows the first turning angle to be minimized; and
a notch forming section configured to form a notch in the notch forming candidate position selected by the notch formation controller, at the monocrystal for slicing.

11. The cylindrical grinding apparatus according to any one of claims 6 to 8, further comprising:
a notch formation controller configured to select, of a plurality of notch forming candidate positions representing the target plane orientation, a notch forming candidate position that allows the second turning angle to be minimized; and
a notch forming section configured to form a notch in the notch forming candidate position selected by the notch formation controller, at the monocrystal for slicing.

12. A cylindrical grinding method of producing a monocrystal for slicing by cylindrically grinding an outer circumferential surface of a monocrystal for grinding while rotating the monocrystal for grinding around a rotation axis, the cylindrical grinding method comprising:
correcting an attitude of the monocrystal for grinding to incline a center axis of the monocrystal for grinding with respect to the rotation axis, by performing a rotation and a turn based on a plane orientation difference between a plane orientation of the monocrystal for grinding and a target plane orientation of a wafer to be obtained by slicing the monocrystal for slicing, in the rotation the monocrystal for grinding being rotated around the center axis, in the turn the monocrystal for grinding being turned around a turn axis orthogonal to the center axis; and
performing grinding, by cylindrically grinding the outer circumferential surface of the monocrystal for grinding while rotating the monocrystal for grinding whose attitude has been corrected around the rotation axis.

13. The cylindrical grinding method according to claim 12, wherein
a rotation section to hold and rotate the monocrystal for grinding around the rotation axis and a turn section to perform the turn are used, and
in the correcting the attitude, the rotation section is controlled to hold the monocrystal for grinding and perform the rotation in a state where the center axis is coincident with the rotation axis, and then the turn section is controlled to receive the monocrystal for grinding from the rotation section, perform the turn, and then return to the rotation section the monocrystal for grinding in an attitude in which the center axis is inclined with respect to the rotation axis.

14. The cylindrical grinding method according to claim 13, further comprising:
calculating a correction amount by obtaining a first rotation angle for the rotation and a first turning angle for the turn based on the plane orientation difference, wherein
the first rotation angle and the first turning angle enable a plane orientation of the monocrystal for slicing to coincide with the target plane orientation,
in the correcting the attitude, the rotation section is controlled to perform the rotation based on the first rotation angle, and then the turn section is controlled to perform the turn based on the first turning angle, and
in the performing the grinding, the monocrystal for slicing whose plane orientation coincides with the target plane orientation is produced, by cylindrically grinding the outer circumferential surface of the monocrystal for grinding whose attitude has been corrected based on the first rotation angle and the first turning angle.

15. The cylindrical grinding method according to claim 14, further comprising:
determining a grinding possibility, in which it is determined whether it is possible to cylindrically grind an entire outer circumferential surface of the monocrystal for grinding that has been turned by the first turning angle, based on a length and a diameter of the monocrystal for grinding and a target diameter of the monocrystal for slicing, wherein
when it is determined, in the determining the grinding possibility, to be possible to cylindrically grind the entire outer circumferential surface of the monocrystal for grinding that has been turned by the first turning angle, the monocrystal for slicing whose plane orientation coincides with the target plane orientation is produced in the correcting the attitude and the performing the grinding.

16. The cylindrical grinding method according to claim 15, wherein
when it is determined, in the determining the grinding possibility, to be impossible to cylindrically grind the entire outer circumferential surface of the monocrystal for grinding that has been turned by the first turning angle, a second rotation angle for the rotation and a second turning angle for the turn are obtained based on the plane orientation difference in the calculating the correction amount, the second turning angle being smaller than the first turning angle,
the second rotation angle and the second turning angle do not enable the plane orientation of the monocrystal for slicing to coincide with the target plane orientation, and by rotating the monocrystal for slicing, in which a relationship between the plane orientation and a slicing start position is a predetermined relationship, by a set rotation angle around the center axis and then turning the monocrystal for slicing around the turn axis orthogonal to the center axis, the second rotation angle and the second turning angle enable the plane orientation of the monocrystal for slicing to coincide with the target plane orientation when viewed from a direction of the center axis before turning the monocrystal for slicing, and
when the second rotation angle and the second turning angle are obtained in the calculating the correction amount, the rotation section is controlled to perform the rotation based on the second rotation angle and then the turn section is controlled to perform the turn based on the second turning angle in the correcting the attitude, and the monocrystal for slicing whose plane orientation does not coincide with the target plane orientation is produced by cylindrically grinding the outer circumferential surface of the monocrystal for grinding whose attitude has been corrected based on the second rotation angle and the second turning angle in the performing the grinding.

17. The cylindrical grinding method according to claim 16, wherein
in the determining the grinding possibility, it is determined whether it is possible to cylindrically grind the entire outer circumferential surface of the monocrystal for grinding that has been turned by the second turning angle, based on the length and the diameter of the monocrystal for grinding and the target diameter of the monocrystal for slicing,
when it is determined, in the determining the grinding possibility, to be possible to cylindrically grind the entire outer circumferential surface of the monocrystal for grinding that has been turned by the second turning angle, the monocrystal for slicing whose plane orientation does not coincide with the target plane orientation is produced in the correcting the attitude and the performing the grinding, and
when it is determined to be impossible to cylindrically grind the entire outer circumferential surface of the monocrystal for grinding that has been turned by the second turning angle, the monocrystal for slicing whose plane orientation does not coincide with the target plane orientation is not produced in the correcting the attitude and the performing the grinding.

18. The cylindrical grinding method according to any one of claims 12 to 17, further comprising:
forming a notch at the monocrystal for slicing, the notch representing the target plane orientation.

19. The cylindrical grinding method according to claim 14 or 15, further comprising:
controlling notch formation by selecting, of a plurality of notch forming candidate positions representing the target plane orientation, a notch forming candidate position that allows the first turning angle to be minimized; and
forming a notch in the notch forming candidate position selected in the controlling the notch formation, at the monocrystal for slicing.

20. The cylindrical grinding method according to claim 16 or 17, further comprising:
controlling notch formation by selecting, a plurality of notch forming candidate positions representing the target plane orientation, a notch forming candidate position that allows the second turning angle to be minimized; and
forming a notch in the notch forming candidate position selected in the controlling the notch formation, at the monocrystal for slicing.

21. A wafer manufacturing method comprising:
producing a monocrystal for slicing from a monocrystal for grinding by the cylindrical grinding method according to claim 12; and
manufacturing a plurality of wafers by slicing the monocrystal for slicing, the plurality of wafers each having a plane orientation coinciding with the target plane orientation.
